# EUROPEAN PATENT SPECIFICATION

(11) **EP 2 458 579 B1**
(45) Date of publication and mention of the grant of the patent: **20.09.2017**
(21) Application number: 12156251.6
(22) Date of filing: 05.01.2007
(51) Int. Cl.: G09G 3/22, G09G 3/32

(54) **Method and system for driving an active matrix display circuit**
Verfahren und System zur Ansteuerung einer Aktivmatrixanzeigeschaltung
Procédé et système de commande d'un circuit d'affichage à matrice active

(30) Priority: 09.01.2006 CA 2535233; 27.06.2006 CA 2551237
(43) Date of publication of application: 30.05.2012
(62) Divisional of application: 07701644.2
(73) Proprietor: Ignis Innovation Inc., Waterloo, Ontario N2V 2C5 (CA)
(72) Inventor: Nathan, Arokia, Cambridge Cambridgeshire CB3 ODL (GB); Chaji, Gholamreza, Waterloo Ontario N2V 2S3 (CA)
(74) Representative: Grünecker Patent- und Rechtsanwälte PartG mbB

(56) References cited:
- WO-A1-2005/122121
- WO-A2-2005/022498
- US-A1- 2003 122 747

## Description

### FIELD OF INVENTION

The invention relates to a light emitting device, and more specifically to a method and system for driving a pixel circuit having a light emitting device.

### BACKGROUND OF THE INVENTION

Electro-luminance displays have been developed for a wide variety of devices, such as cell phones. In particular, active-matrix organic light emitting diode (AMOLED) displays with amorphous silicon (a-Si), poly-silicon, organic, or other driving backplane have become more attractive due to advantages, such as feasible flexible displays, its low cost fabrication, high resolution, and a wide viewing angle.

An AMOLED display includes an array of rows and columns of pixels, each having an organic light emitting diode (OLED) and backplane electronics arranged in the array of rows and columns. Since the OLED is a current driven device, the pixel circuit of the AMOLED should be capable of providing an accurate and constant drive current.

There is a need to provide a method and system that is capable of providing constant brightness with high accuracy and reducing the effect of the aging of the pixel circuit and the instability of backplane and a light emitting device.

Document US 2003/0122747 A1 describes an active matrix electroluminescent display device in which the drive current through an electroluminescent display element in each pixel in a drive period is controlled by a driving device based on a drive signal applied during a preceding address period and stored as a voltage on an associated storage capacitor. In order to counteract the effects of display element ageing, through which the light output for a given drive signal level diminishes over time, the pixel includes electro-optic discharging means coupled to the storage capacitor and responsive to the display element's light output of the display element in the drive period.

Document WO 2005/022498 A2 describes an active matrix display which has a light-dependent device for detecting the brightness of the display element and threshold voltage measurement circuitry for measuring a threshold voltage of a pixel the drive transistor. Compensation for ageing of the display element is provided by an optical feedback path, and compensation for drive transistor threshold variations is provided by measurement of the threshold voltage.

Document WO 2005/122121 A1 describes an active matrix display device which has an array of display pixels, each pixel comprising a current-driven light emitting display element, a drive transistor for driving a current through the display element and pixel circuitry including an optical feedback element, for controlling the drive transistor to drive a substantially constant current through the display element for a duration which depends on the desired display pixel output level and an optical feedback signal of the optical feedback element. An output configuration is applied to the display which includes values of the pixel power supply voltages, the field period and an allowed range of pixel drive levels. The output configuration is varied in response to ageing of the display element.

### SUMMARY OF THE INVENTION

It is an object of the invention to provide a method and system that obviates or mitigates at least one of the disadvantages of existing systems.
This object is solved by the present invention as defined in the independent claims. Advantageous embodiments of the present invention are defined by the dependent claims.

In accordance with an illustrative example for understanding the present invention there is provided a system a display system, including a drive circuit for a pixel having a light emitting device. The drive circuit includes a drive transistor connected to the light emitting device. The drive transistor includes a gate terminal, a first terminal and a second terminal. The drive circuit includes a first transistor including a gate terminal, a first terminal and a second terminal, the gate terminal of the first transistor being connected to a select line, the first terminal of the first transistor being connected to a data line, the second terminal of the first transistor being connected to the gate terminal of the drive transistor. The drive circuit includes a circuit for adjusting the gate voltage of the drive transistor, the circuit including a discharging transistor having a gate terminal, a first terminal and a second terminal, the gate terminal of the discharging transistor being connected to the gate terminal of the drive transistor at a node, the voltage of the node being discharged through the discharging transistor. The drive circuit includes a storage capacitor including a first terminal and a second terminal, the first terminal of the storage capacitor being connected to the gate terminal of the drive transistor at the node.

The display system may include a display array having a plurality of pixel circuits arranged in rows and columns, each of the pixel circuits including the drive circuit, and a driver for driving the display array. The gate terminal of the second transistor is connected to a bias line. The bias line may be shared by more than one pixel circuit of the plurality of pixel circuits.

In accordance with a further illustrative example for understanding the present invention there is provided a method for the display system. The display system includes a driver for providing a programming cycle, a compensation cycle and a driving cycle for each row. The method includes the steps of at the programming cycle for a first row, selecting the address line for the first row and providing programming data to the first row, at the compensation cycle for the first row, selecting the adjacent address line for a second row adjacent to the first row and disenabling the address line for the first row, and at the driving cycle for the first row, disenabling the adjacent address line.

In accordance with a further illustrative example for understanding the present invention there is provided a display system, including one or more than one pixel circuit, each including a light emitting device and a drive circuit. The drive circuit includes a drive transistor including a gate terminal, a first terminal and a second terminal, the drive transistor being between the light emitting device and a first power supply. The drive circuit includes a switch transistor including a gate terminal, a first terminal and a second terminal, the gate terminal of the switch transistor being connected to a first address line, the first terminal of the switch transistor being connected to a data line, the second terminal of the switch transistor being connected to the gate terminal of the drive transistor. The drive circuit includes a circuit for adjusting the gate voltage of the drive transistor, the circuit including a sensor for sensing energy transfer from the pixel circuit and a discharging transistor, the sensor having a first terminal and a second terminal, a property of the sensor varying in dependence upon the sensing result, the discharging transistor having a gate terminal, a first terminal and a second terminal, the gate terminal of the discharging transistor being connected to a second address line, the first terminal of the discharging transistor being connected to the gate terminal of the drive transistor at a node, the second terminal of the discharging transistor being connected to the first terminal of the sensor. The drive circuit includes a storage capacitor including a first terminal and a second terminal, the first terminal of the storage capacitor being connected to the gate terminal of the drive transistor at the node.

In accordance with a further illustrative example for understanding the present invention there is provided a method for a display system, including the step of implementing an in-pixel compensation.

In accordance with a further illustrative example for understanding the present invention there is provided a method for a display system, including the step of implementing an of-panel compensation.

In accordance with a further illustrative example for understanding the present invention there is provided a method for a display system, which includes a pixel circuit having a sensor, including the step of reading back the aging of the sensor.

In accordance with a further illustrative example for understanding the present invention there is provided a display system, including a display array including a plurality of pixel circuits arranged in rows and columns, each including a light emitting device and a drive circuit; and a drive system for driving the display array. The drive circuit includes a drive transistor including a gate terminal, a first terminal and a second terminal, the drive transistor being between the light emitting device and a first power supply. The drive circuit includes a first transistor including a gate terminal, a first terminal and a second terminal, the gate terminal of the first transistor being connected to an address line, the first terminal of the first transistor being connected to a data line, the second terminal of the first transistor being connected to the gate terminal of the drive transistor. The drive circuit includes a circuit for adjusting the gate voltage of the drive transistor, the circuit including a second transistor, the second transistor having a gate terminal, a first terminal and a second terminal, the gate terminal of the second transistor being connected to a control line, the first terminal of the second transistor being connected to the gate terminal of the drive transistor. The drive circuit includes a storage capacitor including a first terminal and a second terminal, the first terminal of the storage capacitor being connected to the gate terminal of the drive transistor. The drive system drives the pixel circuit so that the pixel circuit is turned off for a portion of a frame time.

In accordance with a further illustrative example for understanding the present invention there is provided a method for a display system having a display array and a driver system. The drive system provides a frame time having a programming cycle, a discharge cycle, an emission cycle, a reset cycle, and a relaxation cycle, for each row. The method includes the steps of at the programming cycle, programming the pixel circuits on the row by activating the address line for the row; at the discharge cycle, partially discharging the voltage on the gate terminal of the drive transistor by deactivating the address line for the row and activating the control line for the row; at the emission cycle, deactivating the control line for the row, and controlling the light emitting device by the drive transistor; at the reset cycle, discharging the voltage on the gate terminal of the drive transistor by activating the control line for the row; and at the relaxation cycle, deactivating the control line for the row.

### BRIEF DESCRIPTION OF THE DRAWINGS

These and other features of the invention will become more apparent from the following description in which reference is made to the appended drawings wherein:
Figure 1 is a diagram illustrating an example of a pixel circuit to which a pixel drive scheme in accordance with comparative example for undestanding the present invention is applied;
Figure 2 is a diagram illustrating another example of a pixel circuit having a drive circuit of Figure 1;
Figure 3 is a timing diagram for an example of a method of driving a pixel circuit in accordance with comparative example for understanding the present invention;
Figure 4 is a diagram illustrating an example of a display system for the drive circuit of Figures 1 and 2;
Figure 5 is a diagram illustrating an example of a pixel circuit to which a pixel drive scheme in accordance with another comparative example for understanding the present invention is applied;
Figure 6 is a diagram illustrating another example of a drive circuit of Figure 5;
Figure 7 is a diagram illustrating a further example of the drive circuit of Figure 5;
Figure 8 is a diagram illustrating another example of a pixel circuit having the drive circuit of Figure 5;
Figure 9 is a timing diagram for an example of a method of driving a pixel circuit in accordance with another comparative example for understanding the present invention;
Figure 10 is a diagram illustrating an example of a display system for the drive circuit of Figures 5 and 8;
Figure 11 is a diagram illustrating an example of a display system for the drive circuit of Figures 6 and 7;
Figure 12 is a graph illustrating simulation results for the pixel circuit of Figure 1;
Figure 13 is a diagram illustrating an example of a pixel circuit to which a pixel drive scheme in accordance with a further comparative example for understanding the present invention is applied;
Figure 14 is a diagram illustrating another example of a pixel circuit having a drive circuit of Figure 13;
Figure 15 is a timing diagram for an example of a method of driving a pixel circuit in accordance with a further comparative example for understanding the present invention;
Figure 16 is a diagram illustrating an example of a display system for the drive circuit of Figures 13 and 14;
Figure 17 is a graph illustrating simulation results for the pixel circuit of Figure 5;
Figure 18 is a graph illustrating simulation results for the pixel circuit of Figure 5;
Figure 19 is a timing diagram for the operation of the display system of Figure 16.
Figure 20 is a diagram illustrating an example of a pixel circuit to which a pixel drive scheme in accordance with an embodiment of the present invention is applied;
Figure 21 is a diagram illustrating anther example of a pixel circuit having the drive circuit of Figure 20;
Figure 22 is a timing diagram illustrating an example of a method of driving a pixel circuit in accordance with a further embodiment of the present invention;
Figure 23 is a diagram illustrating an example of a display system for the drive circuit of Figures 20 and 21;
Figure 24 is a diagram illustrating another example of a display system for the drive circuit of Figures 20 and 21;
Figure 25 is a diagram illustrating an example of a pixel system in accordance with an embodiment of the present invention;
Figure 26 is a diagram illustrating an example of a display system having a read back circuit of Figure 25;
Figure 27 is a diagram illustrating another example of a display system having the read back circuit of Figure 25;
Figure 28 is a timing diagram illustrating an example of a method of driving a pixel circuit in accordance with a further embodiment of the present invention;
Figure 29 is a diagram illustrating an example of a method of extracting the aging of a sensor of Figure 25;
Figure 30 is a diagram illustrating an example of a pixel system in accordance with another embodiment of the present invention;
Figure 31 is a diagram illustrating an example of a display system having a read back circuit of Figures 30;
Figure 32 is a diagram illustrating another example of a display system having the read back circuit of Figure 30;
Figure 33 is a timing diagram illustrating an example of a method of driving a pixel circuit in accordance with a further embodiment of the present invention;
Figure 34 is a timing diagram illustrating another example of a method of extracting the aging of a sensor of Figure 30;
Figure 35 is a diagram illustrating an example of a pixel circuit to which a pixel drive scheme in accordance with a further embodiment of the present invention is applied;
Figure 36 is a timing diagram for an example of a method of driving a pixel circuit in accordance with a further embodiment of the present invention;
Figure 37 is a diagram illustrating an example of a display system having the pixel circuit of Figure 35; and
Figure 38 is a diagram illustrating another example of a display system having the pixel circuit of Figure 35.

### DETAILED DESCRIPTION

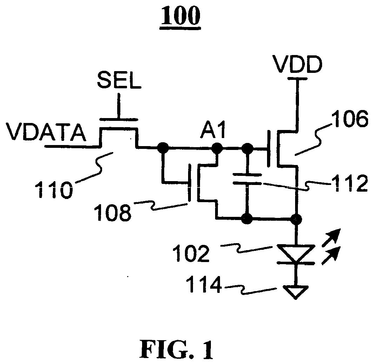

Figure 1 illustrates an example of a pixel circuit to which a pixel drive scheme in a comparative example for understanding accordance with a comparative example for understanding the present invention is applied. The pixel circuit 100 of Figure 1 includes an OLED 102 and a drive circuit 104 for driving the OLED 102. The drive circuit 104 includes a drive transistor 106, a discharging transistor 108, a switch transistor 110, and a storage capacitor 112. The OLED 102 includes, for example, an anode electrode, a cathode electrode and an emission layer between the anode electrode and the cathode electrode.

In the description below, "pixel circuit" and "pixel" are used interchangeably. In the description below, "signal" and "line" may be used interchangeably. In the description below, the terms "line" and "node" may be used interchangeably. In the description, the terms "select line" and "address line" may be used interchangeably. In the description below, "connect (or connected)"and "couple (or coupled)" may be used interchangeably, and may be used to indicate that two or more elements are directly or indirectly in physical or electrical contact with each other.

In one example, the transistors 106, 108 and 110 are n-type transistors. In another example, the transistors 106, 108 and 110 are p-type transistors or a combination of n-type and p-type transistors. In one example, each of the transistors 106, 108 and 110 includes a gate terminal, a source terminal and a drain terminal.

The transistors 106, 108 and 110 may be fabricated using amorphous silicon, nano/micro crystalline silicon, poly silicon, organic semiconductors technologies (e.g., organic TFT), NMOS/PMOS technology or CMOS technology (e.g., MOSFET).

The drive transistor 106 is provided between a voltage supply line VDD and the OLED 102. One terminal of the drive transistor 106 is connected to VDD. The other terminal of the drive transistor 106 is connected to one electrode (e.g., anode electrode) of the OLED 102. One terminal of the discharging transistor 108 and its gate terminal are connected to the gate terminal of drive transistor 106 at node A1. The other terminal of the discharging transistor 108 is connected to the OLED 102. The gate terminal of the switch transistor 110 is connected to a select line SEL. One terminal of the switch transistor 110 is connected to a data line VDATA. The other terminal of the switch transistor 110 is connected to node A1. One terminal of the storage capacitor 112 is connected to node A1. The other term inal of the storage capacitor 112 is connected to the OLED 102. The other electrode (e.g., cathode electrode) of the OLED 102 is connected to a power supply line (e.g., common ground) 114.

The pixel circuit 100 provides constant averaged current over the frame time by adjusting the gate voltage of the drive transistor 106, as described below.

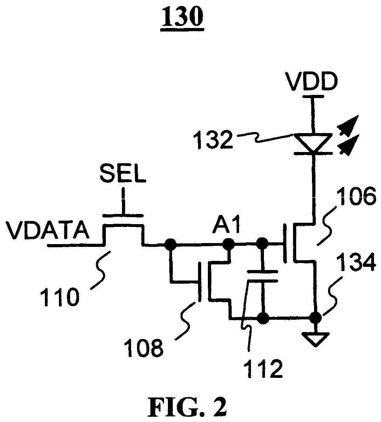

Figure 2 illustrates anther example of a pixel circuit having the drive circuit 104 of Figure 1. The pixel circuit 130 is similar to the pixel circuit 100 of Figure 1. The pixel circuit 130 includes an OLED 132. The OLED 132 may be same or similar to the OLED 102 of Figure 1. In the pixel circuit 130, the drive transistor 106 is provided between one electrode (e.g., cathode electrode) of the OLED 132 and a power supply line (e.g., common ground) 134. One terminal of the discharging transistor 138 and one terminal of the storage capacitor 112 are connected to the power supply line 134. The other electrode (e.g., anode electrode) of the OLED 132 is connected to VDD.

The pixel circuit 130 provides constant averaged current over the frame time, in a manner similar to that of the pixel circuit 100 of Figure 1.

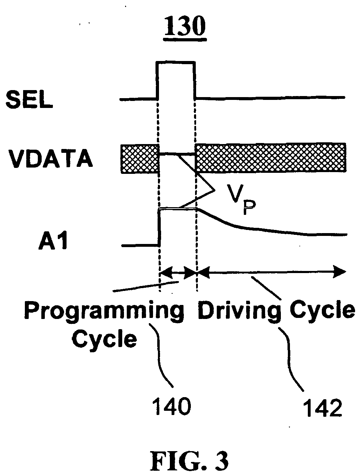

Figure 3 illustrates an example of method of driving a pixel circuit in accordance with a comparative example for understanding the present invention. The waveforms of Figure 3 are applied to a pixel circuit (e.g., 100 of Figure 1, 130 of Figure 2) having the drive circuit 104 of Figures 1 and 2.

The operation cycle of Figure 3 includes a programming cycle 140 and a driving cycle 142. Referring to Figures 1 to 3, during the programming cycle 140, node A1 is charged to a programming voltage through the switch transistor 110 while the select line SEL is high. During the driving cycle 142, node A1 is discharged through the discharging transistor 108. Since the drive transistor 106 and the discharging transistor 108 have the same bias condition, they experience the same threshold voltage shift. Considering that the discharge time is a function of transconductance of the discharging transistor 108, the discharge time increases as the threshold voltage of the drive transistor 106/the discharging transistor 108 increases. Therefore, the average current of the pixel (100 of Figure 1, 130 of Figure 2) over the frame time remains constant. In an example, the discharging transistor is a very weak transistor with short width (W) and long channel length (L). The ratio of the width (W) to the length (L) may change based on different situations.

In addition, in the pixel circuit 130 of Figure 2, an increase in the OLED voltage for the OLED 132 results in longer discharge time. Thus, the averaged pixel current will remain constant even after the OLED degradation.

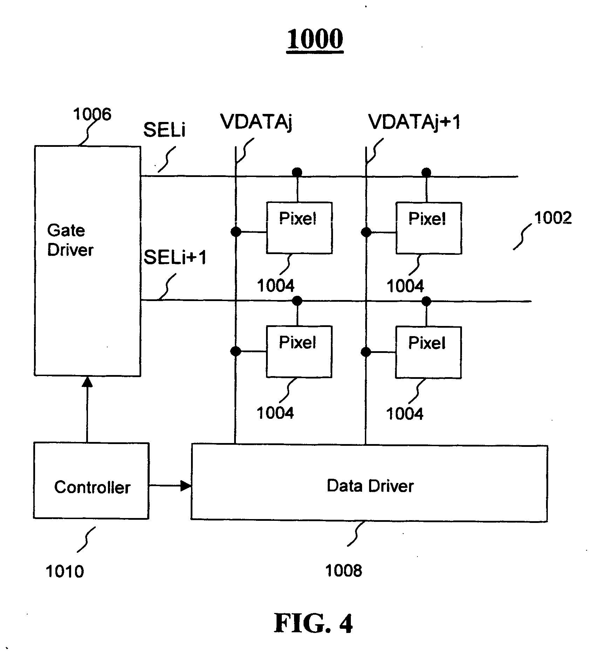

Figure 4 illustrates an example of a display system for the drive circuit of Figures 1 and 2. The display system 1000 of Figure 4 includes a display array 1002 having a plurality of pixels 1004. The pixel 1004 includes the drive circuit 104 of Figures 1 and 2, and may be the pixel circuit 100 of Figure 1 or the pixel circuit 130 of Figure 2.

The display array 1002 is an active matrix light emitting display. In one example, the display array 1002 is an AMOLED display array. The display array 1002 may be a single color, multi-color or a fully color display, and may include one or more than one electroluminescence (EL) element (e.g., organic EL). The display array 1002 may be used in mobiles, personal digital assistants (PDAs), computer displays, or cellular phones.

Select lines SELi and SELi+1 and data lines VDATAj and VDATAJ+ are provided to the display array 1002. Each of the select lines SELi and SELi+1 corresponds to SEL of Figures 1 and 2. Each of the data lines VDATAj and VDATAj+1 corresponds to VDATA of Figures 1 and 2. The pixels 1004 are arranged in rows and columns. The select line (SELi, SELi+1) is shared between common row pixels in the display array 1002. The data line (VDATAj, VDATAj+1) is shared between common column pixels in the display array 1002.

In Figure 4, four pixels 1004 are shown. However, the number of the pixels 1004 may vary in dependence upon the system design, and does not limited to four. In Figure 4, two select lines and two data lines are shown. However, the number of the select lines and the data lines may vary in dependence upon the system design, and does not limited to two.

A gate driver 1006 drives SELi and SELi+1. The gate driver 1006 may be an address driver for providing address signals to the address lines (e.g., select lines). A data driver 1008 generates a programming data and drives VDATAj and VDATAj+1. A controller 1010 controls the drivers 1006 and 1008 to drive the pixels 1004 as described above.

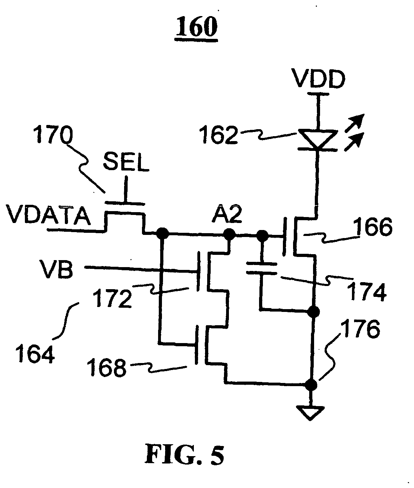

Figure 5 illustrates an example of a pixel circuit to which a pixel drive scheme in accordance with another comparative example for understanding the present invention. The pixel circuit 160 of Figure 5 includes an OLED 162 and a drive circuit 164 for driving the OLED 162. The drive circuit 164 includes a drive transistor 166, a discharging transistor 168, first and second switch transistors 170 and 172, and a storage capacitor 174.

The pixel circuit 160 is similar to the pixel circuit 130 of Figure 2. The drive circuit 164 is similar to the drive circuit 104 of Figures 1 and 2. The transistors 166, 168 and 170 correspond to the transistors 106, 108 and 110 of Figures 1 and 2, respectively. The transistors 166, 168, and 170 may be same or similar to the transistors 106, 108 and 110 of Figures 1 and 2. The storage capacitor 174 corresponds to the storage capacitor 112 of Figures 1 and 2. The storage capacitor 174 may be same or similar to the storage capacitor 112 of Figures 1 and 2. The OLED 162 corresponds to the OLED 132 of Figure 2. The OLED 162 may be same or similar to the OLED 132 of Figure 2.

In one example, the switch transistor 172 is a n-type transistor. In another example, the switch transistor 172 is a p-type transistor. In one example, each of the transistors 166, 168, 170, and 172 includes a gate terminal, a source terminal and a drain terminal.

The transistors 166, 168, 170 and 172 may be fabricated using amorphous silicon, nano/micro crystalline silicon, poly silicon, organic semiconductors technologies (e.g., organic TFT), NMOS/PMOS technology or CMOS technology (e.g., MOSFET).

In the pixel circuit 160, the switch transistor 172 and the discharging transistor 168 are connected in series between the gate terminal of the drive transistor 166 and a power supply line (e.g., common ground) 176. The gate terminal of the switch transistor 172 is connected to a bias voltage line VB. The gate terminal of the discharging transistor 168 is connected to the gate terminal of the drive transistor at node A2. The drive transistor 166 is provided between one electrode (e.g., cathode electrode) of the OLED 162 and the power supply line 176. The gate terminal of the switch transistor 170 is connected to SEL. One terminal of the switch transistor 170 is connected to VDATA. The other terminal of the switch transistor 170 is connected to node A2. One terminal of the storage capacitor 174 is connected to node A2. The other terminal of the storage capacitor 174 is connected to the power supply line 176.

The pixel circuit 160 provides constant averaged current over the frame time by adjusting the gate voltage of the drive transistor 166, as described below.

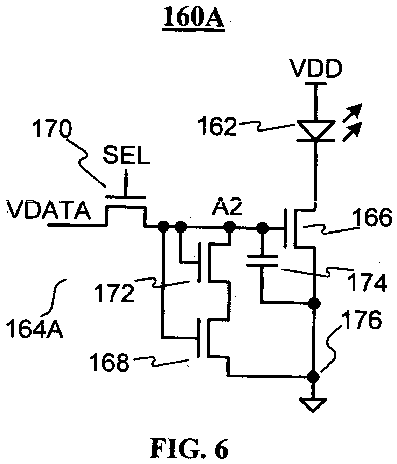

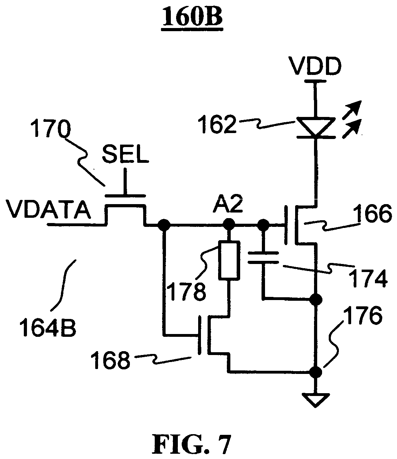

In one example, the bias voltage line VB of Figure 5 may be shared between the pixels of the entire panel. In another example, the bias voltage VB may be connected to node A2, as shown in Figure 6. The pixel circuit 160A of Figure 6 includes a drive circuit 164A. The drive circuit 164A is similar to the drive circuit 164 of Figure 5. However, in the drive circuit 164A, the gate terminal of the switch transistor 172 is connected to node A2. In a further example, the switch transistor 172 of Figure 5 may be replaced with a resistor, as shown in Figure 7. The pixel circuit 160B of Figure 7 includes a drive circuit 164B. The drive circuit 164B is similar to the drive circuit 164 of Figure 5. However, in the drive circuit 164B, a resistor 178 and the discharging transistor 168 are connected in series between node A2 and the power supply line 176.

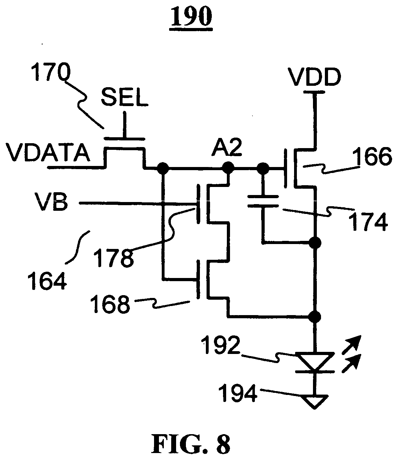

Figure 8 illustrates another example of a pixel circuit having the drive circuit 164 of Figure 5. The pixel circuit 190 is similar to the pixel circuit 160 of Figure 5. The pixel circuit 190 includes an OLED 192. The OLED 192 may be same or similar to the OLED 162 of Figure 5. In the pixel circuit 190, the drive transistor 166 is provided between one electrode (e.g., anode electrode) of the OLED 192 and VDD. One terminal of the discharging transistor 168 and one terminal of the storage capacitor 174 are connected to the OLED 192. The other electrode (e.g., cathode electrode) of the OLED 192 is connected to a power supply line (e.g., common ground) 194.

In one example, the bias voltage VB of Figure 8 is shared between the pixels of the entire panel. In another example, the bias voltage VB of Figure 8 is connected to node A2, as it is similar to that of Figure 6. In a further example, the switch transistor 172 of Figure 8 is replaced with a resistor, as it is similar to that of Figure 7.

The pixel circuit 190 provides constant averaged current over the frame time, in a manner similar to that of the pixel circuit 160 of Figure 5.

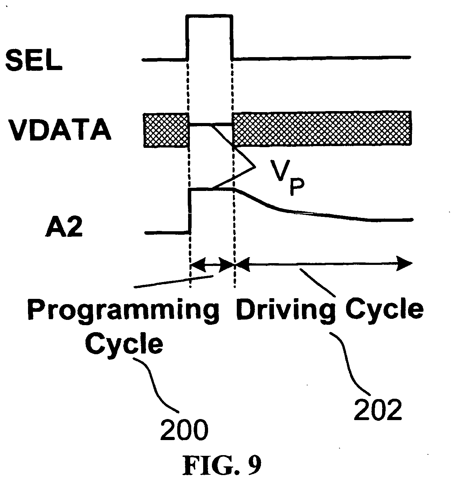

Figure 9 illustrates an example of method of driving a pixel circuit in accordance with comparative example for understanding another comparative example for understanding the present invention. The waveforms of Figure 9 are applied to a pixel circuit (e.g., 160 of Figure 5, 190 of Figure 8) having the drive circuit 164 of Figures 5 and 8.

The operation cycle of Figure 9 includes a programming cycle 200 and a driving cycle 202. Referring to Figures 5, 8 and 9, during the programming cycle 200, node A2 is charged to a programming voltage (Vp) through the switch transistor 170 while SEL is high. During the driving cycle 202, node A2 is discharged through the discharging transistor 168. Since the drive transistor 166 and the discharging transistor 168 have the same bias condition, they experience the same threshold voltage shift. Considering that the discharge time is a function of transconductance of the discharging transistor 168, the discharge time increases as the threshold voltage of the drive transistor 166/the discharging transistor 168 increases. Therefore, the average current of the pixel (160 of Figure 5, 190 of Figure 8) over the frame time remains constant. Here, the switch transistor 172 forces the discharging transistor 168 in the linear regime of operation, and so reduces feedback gain. Therefore, the discharging transistor 168. may be a unity transistor with the minimum channel length and width. The width and length of the unity transistor are the minimum allowed by the technology.

In addition, in the pixel circuit 190 of Figure 8, an increase in the OLED voltage for the OLED 192 results in longer discharge time. Thus, the averaged pixel current will remain constant even after the OLED degradation.

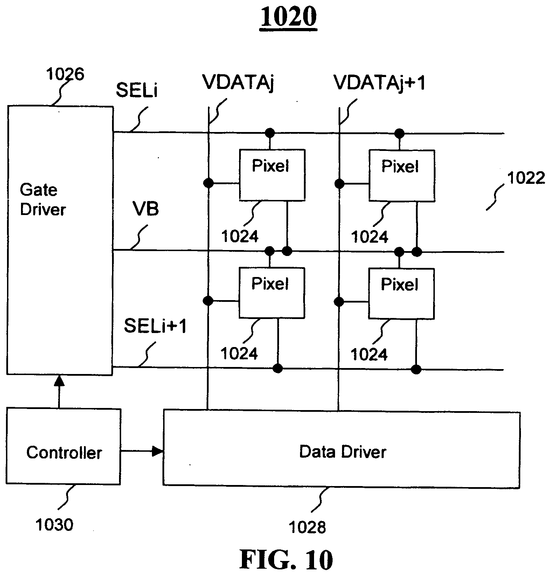

Figure 10 illustrates an example of a display system for the drive circuit of Figures 5 and 8. The display system 1020 of Figure 10 includes a display array 1022 having a plurality of pixels 1024. The pixel 1024 includes the drive circuit 164 of Figures 5 and 8, and may be the pixel circuit 130 of Figure 5 or the pixel circuit 190 of Figure 8.

The display array 1022 is an active matrix light emitting display. In one example, the display array 1022 is an AMOLED display array. The display array 1022 may be a single color, muiti-coior or a fully color display, and may include one or more than one EL element (e.g., organic EL). The display array 1022 may be used in mobiles, PDAs, computer displays, or cellular phones.

Each of select lines SELi and SELi+1 corresponds to SEL of Figures 5 and 8. VB corresponds to VB of Figures 5 and 8. Each of data lines VDATAj and VDATAj+1 corresponds to VDATA of Figures 5 and 8. The pixels 1024 are arranged in rows and columns. The select line (SELi, SELi+1) is shared between common row pixels in the display array 1022. The data line (VDATAj, VDATAj+1) is shared between common column pixels in the display array 1022. The bias voltage line VB is shared by the ith and (i+1)th rows. In another example, the VB may be shared by the entire array 1022.

In Figure 10, four pixels 1024 are shown. However, the number of the pixels 1024 may vary in dependence upon the system design, and does not limited to four. In Figure 10, two select lines and two data lines are shown. However, the number of the select lines and the data lines may vary in dependence upon the system design, and does not limited to two.

A gate driver 1026 drives SELi and SELi+1, and VB. The gate driver 1026 may include an address driver for providing address signals to the display array 1022. A data driver 1028 generates a programming data and drives VDATAj and VDATAj+1. A controller 1030 controls the drivers 1026 and 1028 to drive the pixels 1024 as described above.

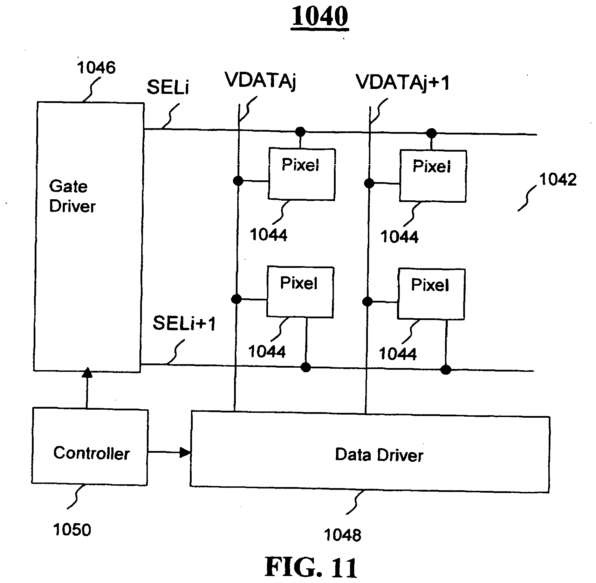

Figure 11 illustrates an example of a display system for the drive circuit of Figures 6 and 7. The display system 1040 of Figure 11 includes a display array 1042 having a plurality of pixels 1044. The pixel 1044 includes the drive circuit 164A of Figure 6 or 164B of Figure 7, and may be the pixel circuit 160A of Figure 6 or the pixel circuit 160B of Figure 7.

The display array 1042 is an active matrix light emitting display. In one example, the display array 1042 is an AMOLED display array. The display array 1042 may be a single color, multi-color or a fully color display, and may include one or more than one EL element (e.g., organic EL). The display array 1042 may be used in mobiles, PDAs, computer displays, or cellular phones.

Each of select lines SELi and SELi+1 corresponds to SEL of Figures 6 and 7. Each of data lines VDATAj and VDATAj+1 corresponds to VDATA of Figures 6 and 7. The pixels 1044 are arranged in rows and columns. The select line (SELi, SELi+1) is shared between common row pixels in the display array 1042. The data line (VDATAj, VDATAj+1) is shared between common column pixels in the display array 1042.

In Figure 11, four pixels 1044 are shown. However, the number of the pixels 1044 may vary in dependence upon the system design, and does not limited to four. In Figure 11, two select lines and two data lines are shown. However, the number of the select lines and the data lines may vary in dependence upon the system design, and does not limited to two.

A gate driver 1046 drives SELi and SELi+1. The gate driver 1046 may be an address driver for providing address signals to the address lines (e.g., select lines). A data driver 1048 generates a programming data and drives VDATAj and VDATAj+1. A controller 1040 controls the drivers 1046 and 1048 to drive the pixels 1044 as described above.

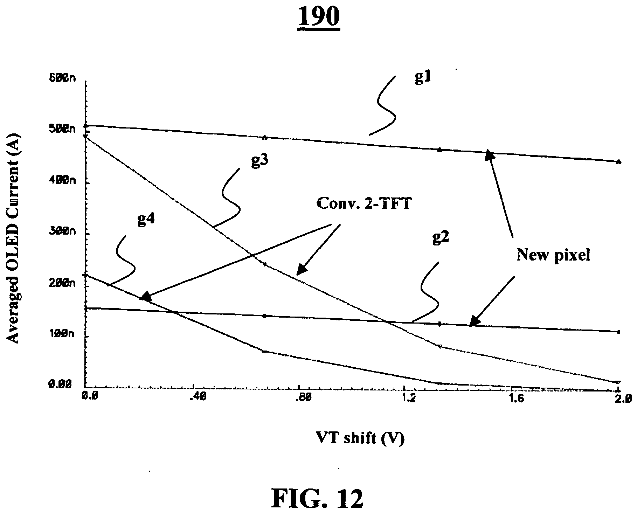

Figure 12 illustrates simulation results for the pixel circuit 100 of Figure 1. In Figure 12, "g1" represents the current of the pixel circuit 100 presented in Figure 1 for different shifts in the threshold voltage of the drive transistor 106 and initial current of 500 nA; "g2" represents the current of the pixel circuit 100 for different shifts in the threshold voltage of the drive transistor 106and initial current of 150 nA. In Figure 12, "g3" represents the current of a conventional 2-TFT pixel circuit for different shifts in the threshold voltage of a drive transistor and initial current of 500 nA; "g4" represents the current of the conventional 2-TFT pixel circuit for different shifts in the threshold voltage of a drive transistor and initial current of 150 nA. It is obvious that the averaged pixel current is stable for the new driving scheme whereas it drops dramatically if the discharging transistor (e.g., 106 of Figure 1) is removed from the pixel circuit (conventional 2-TFT pixel circuit).

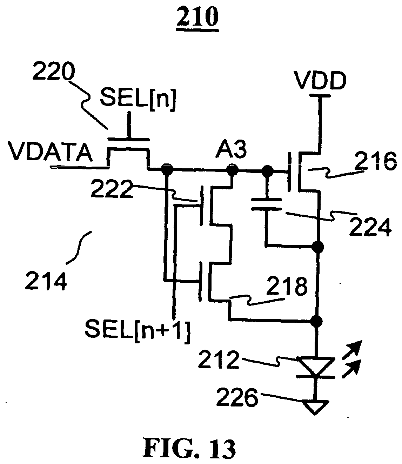

Figure 13 illustrates an example of a pixel circuit to which a pixel drive scheme in accordance with a further comparative example for understanding the present invention. The pixel circuit 210 of Figure 13 includes an OLED 212 and a drive circuit 214 for driving the OLED 212. The drive circuit 214 includes a drive transistor 216, a discharging transistor 218, first and second switch transistors 220 and 222, and a storage capacitor 224.

The pixel circuit 210 is similar to the pixel circuit 190 of Figure 8. The drive circuit 214 is similar to the drive circuit 164 of Figures 5 and 8. The transistors 216, 218 and 220 correspond to the transistors 166, 168 and 170 of Figures 5 and 8, respectively. The transistors 216, 218, and 220 may be same or similar to the transistors 166, 168, and 170 of Figures 5 and 8. The transistor 222 may be same or similar to the transistor 172 of Figure 5 or the transistor 178 of Figure 8. In one example, each of the transistors 216, 218, 220, and 222 includes a gate terminal, a source terminal and a drain terminal. The storage capacitor 224 corresponds to the storage capacitor 174 of Figures 5 to 8. The storage capacitor 224 may be same or similar to the storage capacitor 174 of Figures 5 to 8. The OLED 212 corresponds to the OLED 192 of Figure 8. The OLED 212 may be same or similar to the OLED 192 of Figure 8.

The transistors 216, 218, 220, and 222 may be fabricated using amorphous silicon, nano/micro crystalline silicon, poly silicon, organic semiconductors technologies (e.g., organic TFT), NMOS/PMOS technology or CMOS technology (e.g., MOSFET).

In the pixel circuit 210, the drive transistor 216 is provided between VDD and one electrode (e.g., anode electrode) of the OLED 212. The switch transistor 222 and the discharging transistor 218 are connected in series between the gate terminal of the drive transistor 216 and the OLED 212. One terminal of the switch transistor 222 is connected to the gate terminal of the drive transistor at node A3. The gate terminal of the discharging transistor 218 is connected to node A3. The storage capacitor 224 is provided between node A3 and the OLED 212. The switch transistor 220 is provided between VDATA and node A3. The gate terminal of the switch transistor 220 is connected to a select line SEL[n]. The gate terminal of the switch transistor 222 is connected to a select line SEL [n+1]. The other electrode (e.g., cathode electrode) of the OLED 212 is connected to a power supply line (e.g., common ground) 226. In one example, SEL [n] is the address line of the nth row in a display array, and SEL[n+1] is the address line of the (n+1)th row in the display array.

The pixel circuit 210 provides constant averaged current over the frame time by adjusting the gate voltage of the drive transistor 216, as described below.

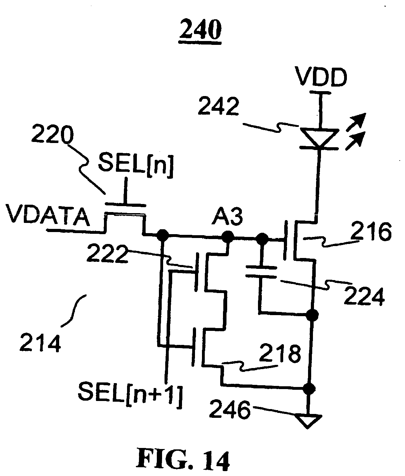

Figure 14 illustrates another example of a pixel circuit having the drive circuit 214 of Figure 3. The pixel circuit 240 of Figure 14 is similar to the pixel circuit 160 of Figure 5. The pixel circuit 240 includes an OLED 242. The OLED 242 may be same or similar to the OLED 162 of Figure 5. In the pixel circuit 240, the drive transistor 216 is provided between one electrode (e.g., cathode electrode) of the OLED 242 and a power supply line (e.g., common ground) 246. One terminal of the discharging transistor 218 and one terminal of the storage capacitor 224 are connected to the power supply line 246. The other electrode (e.g., anode electrode) of the OLED 242 is connected to VDD. The gate terminal of the switch transistor 220 is connected to the select line SEL[n]. The gate terminal of the switch transistor 222 is connected to the select line SEL [n+1].

The pixel circuit 240 provides constant averaged current over the frame time, in a manner similar to that of the pixel circuit 210 of Figure 13.

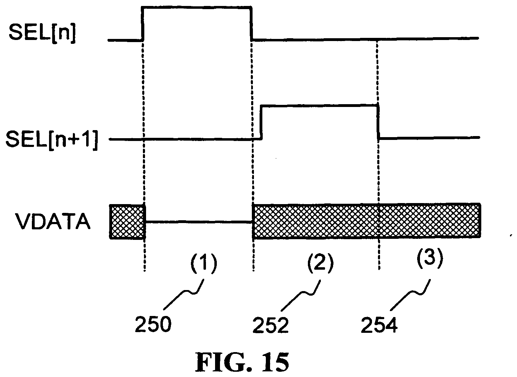

Figure 15 illustrates an example of method of driving a pixel circuit in accordance with a comparative example for understanding the present invention. The waveforms of Figure 15 are applied to a pixel circuit (e.g., 210 of Figure 13, 240 of Figure 14) having the drive circuit 214 of Figures 13 and 14.

The operation cycles of Figure 15 include three operation cycles 250, 252 and 254. The operation cycle 250 forms a programming cycle, the operation cycle 252 forms a compensation cycle, and the operation cycle 254 forms a driving cycle. Referring to Figures 13 to 15, during the programming cycle 250, node A3 is charged to a programming voltage through the switch transistor 220 while SEL[n] is high. During the second operating cycle 252 SEL[n+1] goes to a high voltage. SEL[n] is disenabled (or deactivated). Node A3 is discharged through the discharging transistor 218. During the third operating cycle 254, SEL[n] and SEL[n+1] are disenabled. Since the drive transistor 216 and the discharging transistor 218 have the same bias condition, they experience the same threshold voltage shift. Considering that the discharge time is a function of transconductance of the discharging transistor 218, the discharged voltage decreases as the threshold voltage of the drive transistor 216/the discharging transistor 218 increases. Therefore, the gate voltage of the drive transistor 216 is adjusted accordingly.

In addition, in the pixel 240 of Figure 14, an increase in the OLED voltage for the OLED 242 results in higher gate voltage. Thus, the pixel current remains constant.

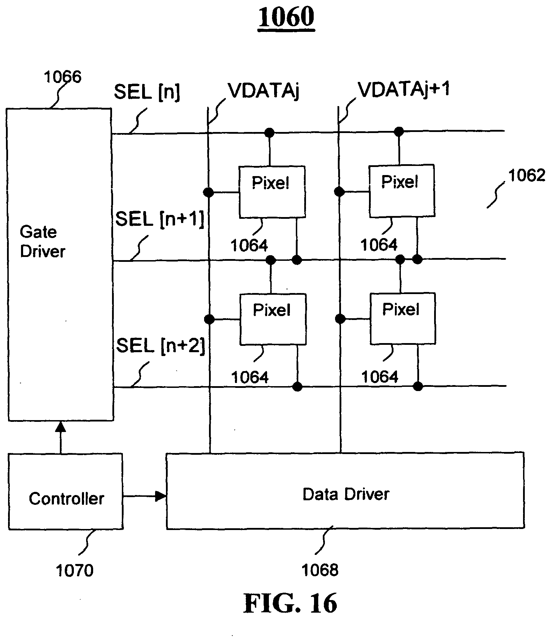

Figure 16 illustrates an example of a display system for the drive circuit of Figures 13 and 14. The display system 1060 of Figure 16 includes a display array 1062 having a plurality of pixels 1064. The pixel 1064 includes the drive circuit 214 of Figures 13 and 14, and may be the pixel circuit 210 of Figure 13 or the pixel circuit 240 of Figure 14.

The display array 1062 is an active matrix light emitting display. In one example, the display array 1062 is an AMOLED display array. The display array 1062 may be a single color, multi-color or a fully color display, and may include one or more than one EL element (e.g., organic EL). The display array 1062 may be used in mobiles, PDAs, computer displays, or cellular phones.

SEL[k] (k=n, n+1, n+2) is an address line for the kth row. VDATA1 (l=j, j+1) is a data line and corresponds to VDATA of Figures 13 and 14. The pixels 1064 are arranged in rows and columns. The select line SEL[k] is shared between common row pixels in the display array 1062. The data line VDATAl is shared between common column pixels in the display array 1062.

In Figure 16, four pixels 1064 are shown. However, the number of the pixels 1064 may vary in dependence upon the system design, and does not limited to four. In Figure 16, three address lines and two data lines are shown. However, the number of the address lines and the data lines may vary in dependence upon the system design.

A gate driver 1066 drives SEL[k]. The gate driver 1066 may be an address driver for providing address signals to the address lines (e.g., select lines). A data driver 1068 generates a programming data and drives VDATAl. A controller 1070 controls the drivers 1066 and 1068 to drive the pixels 1064 as described above.

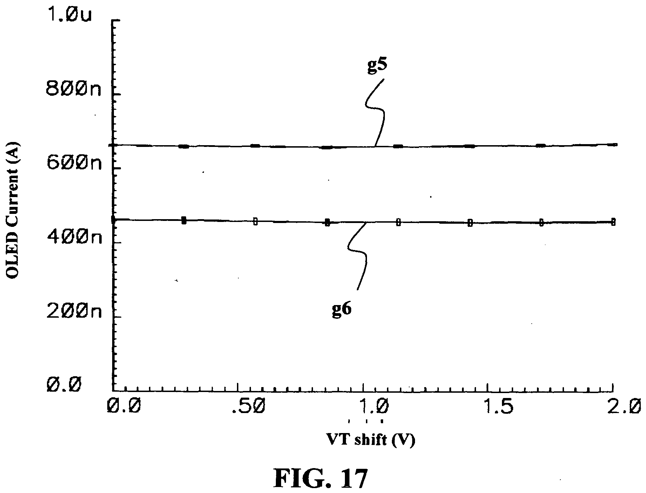

Figure 17 illustrates the simulation results for the pixel circuit 160 of Figure 5. In Figure 17, "g5" represents the current of the pixel circuit 160 presented in Figure 5 for different shifts in the threshold voltage of the drive transistor 166 and initial current of 630 nA; "g6" represents the current of the pixel circuit 160 for different shifts in the threshold voltage of the drive transistor 166 and initial current of 430 nA. It is seen that the pixel current is highly stable even after a 2-V shift in the threshold voltage of the drive transistor. Since the pixel circuit 210 of Figure 13 is similar to the pixel circuit 160 of Figure 15, it is apparent to one of ordinary skill in the art that the pixel current of the pixel circuit 210 will be also stable.

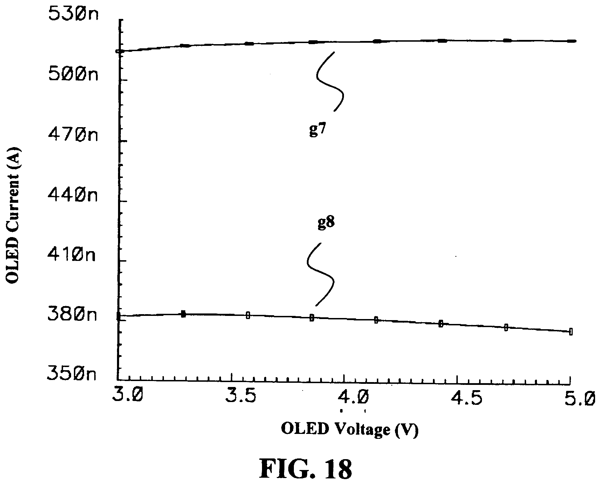

Figure 18 illustrates the simulation results for the pixel circuit 160 of Figure 5. In Figure 18, "g7" represents the current of the pixel circuit 160 presented in Figure 5 for different OLED voltages of the drive transistor 166 and initial current of 515 nA; "g8" represents the current of the pixel circuit 160 for different OLED voltages of the drive transistor 166 and initial current of 380 nA. It is seen that the pixel current is highly stable even after a 2-V shift in the voltage of the OLED. Since the pixel circuit 210 of Figure 13 is similar to the pixel circuit 160 of Figure 15, it is apparent to one of ordinary skill in the art that the pixel current of the pixel circuit 210 will be also stable.

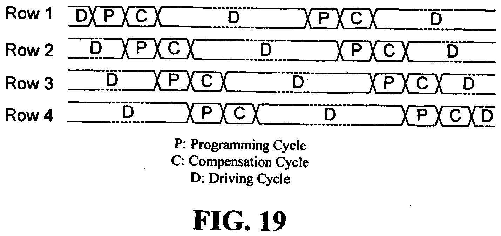

Figure 19 is a diagram showing programming and driving cycles for driving the display arrays 1062 of Figure 16. In Figure 16, each of ROW j (j=1, 2, 3,4) represents thejth row of the display array 1062. In Figure 19, "P" represents a programming cycle; "C" represents a compensation cycle; and "D" represents a driving cycle. The programming cycle P at the jth Row overlaps with the driving cycle D at the (j+1)th Row. The compensation cycle C at the jth Row overlaps with the programming cycle P at the (j+1)th Row. The driving cycle D at the jth Row overlaps with the compensation cycle C at the (j+1)th Row.

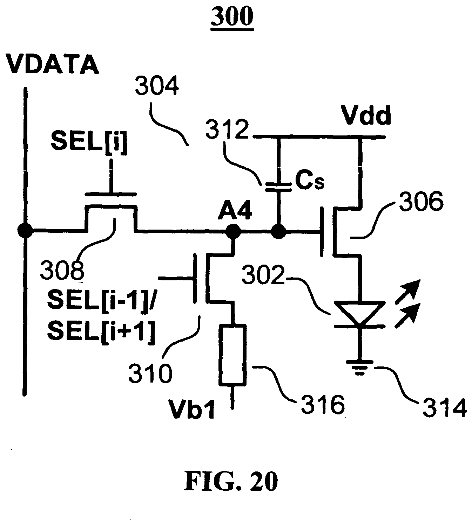

Figure 20 illustrates an example of a pixel circuit to which a pixel drive scheme in accordance with a further embodiment of the present invention is applied. The pixel circuit 300 of Figure 20 includes an OLED 302 and a drive circuit 304 for driving the OLED 302. The drive circuit 304 includes a drive transistor 306, a switch transistor 308, a discharging transistor 310, and a storage capacitor 312. The OLED 302 includes, for example, an anode electrode, a cathode electrode and an emission layer between the anode electrode and the cathode electrode.

In one example, the transistors 306, 308 and 310 are n-type transistors. In another example, the transistors 306, 308 and 310 are p-type transistors or a combination of n-type and p-type transistors. In one example, each of the transistors 306, 308 and 310 includes a gate terminal, a source terminal and a drain terminal. The transistors 306, 308 and 310 may be fabricated using amorphous silicon, nano/micro crystalline silicon, poly silicon, organic semiconductors technologies (e.g., organic TFT), NMOS/PMOS technology or CMOS technology (e.g., MOSFET).

The drive transistor 306 is provided between a voltage supply line Vdd and the OLED 302. One terminal (e.g., source) of the drive transistor 306 is connected to Vdd. The other terminal (e.g., drain) of the drive transistor 306 is connected to one electrode (e.g., anode electrode) of the OLED 302. The other electrode (e.g., cathode electrode) of the OLED 302 is connected to a power supply line (e.g., common ground) 314. One terminal of the storage capacitor 312 is connected to the gate terminal of the drive transistor 306 at node A4. The other terminal of the storage capacitor 312 is connected to Vdd. The gate terminal of the switch transistor 308 is connected to a select line SEL [i]. One terminal of the switch transistor 308 is connected to a data line VDATA. The other terminal of the switch transistor 308 is connected to node A4. The gate terminal of the discharging transistor 310 is connected to a select line SEL [i-1] or SEL[i+1]. In one example, the select line SEL[m] (m=i-1, i+1) is an address line for the mth row in a display array. One terminal of the discharging transistor 310 is connected to node A4. The other terminal of the discharging transistor 310 is connected to a sensor 316. In one example, each pixel includes the sensor 316. In another example, the sensor 316 is shared by a plurality of pixel circuits.

The sensor 316 includes a sensing terminal and a bias terminal Vb1. The sensing terminal of the sensor 316 is connected to the discharging transistor 310. The bias terminal Vb1 may be connected, for example, but not limited to, ground, Vdd or the one terminal (e.g., source) of the drive transistor 306. The sensor 316 detects energy transfer from the pixel circuit. The sensor 316 has a conductance that varies in dependence upon the sensing result. The emitted light or thermal energy by the pixel absorbed by the sensor 316 and so the carrier density of the sensor changes. The sensor 316 provides feedback by, for example, but not limited to, optical, thermal or other means of transduction. The sensor 316 may be, but not limited to, an optical sensor or a thermal sensor. As described below, node A4 is discharged in dependence upon the conductance of the sensor 316.

The drive circuit 304 is used to implement programming, compensating/calibrating and driving of the pixel circuit. The pixel circuit 300 provides constant luminance over the lifetime of its display by adjusting the gate voltage of the drive transistor 306.

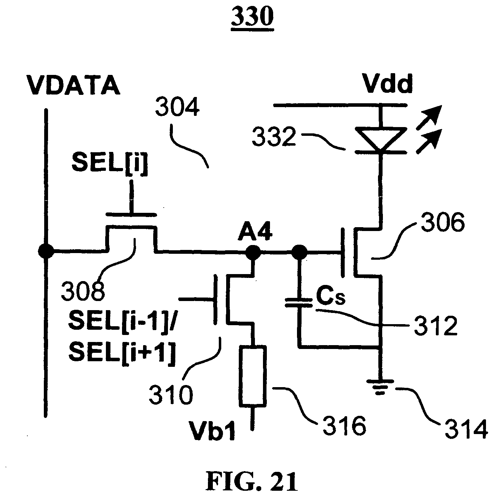

Figure 21 illustrates anther example of a pixel circuit having the drive circuit 304 of Figure 20. The pixel circuit 330 of Figure 21 is similar to the pixel circuit 300 of Figure 20. The pixel circuit 330 includes an OLED 332. The OLED 332 may be same or similar to the OLED 302 of Figure 20. In the pixel circuit 330, one terminal (e.g., drain) of the drive transistor 306 is connected to one electrode (e.g., cathode electrode) of the OLED 332, and the other terminal (e.g., source) of the drive transistor 306 is connected to a power supply line (e.g., common ground) 334. In addition, one terminal of the storage capacitor 312 is connected to node A4, and the other terminal of the storage capacitor 312 is connected to the power supply line 334. The pixel circuit 330 provides constant luminance over the lifetime of its display, in a manner similar to that of the pixel circuit 300 of Figure 20.

Referring to Figures 20 and 21, the aging of the drive transistor 306 and the OLED 302/332 in the pixel circuit are compensated in two different ways: in-pixel compensation and of-panel calibration.

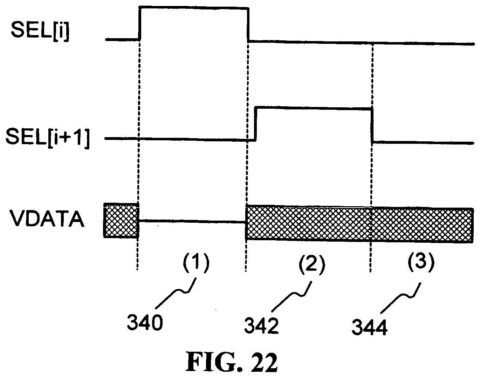

In-pixel compensation is descried in detail. Figure 22 illustrates an example of a method of driving a pixel circuit in accordance with a further embodiment of the present invention. By applying the waveforms of Figure 22 to a pixel having the drive circuit 304 of Figures 20 and 21, the in-pixel compensation is implemented.

The operation cycles of Figure 22 include three operation cycles 340, 342 and 344. The operation cycle 340 is a programming cycle of the ith row and is a driving cycle for the (i+1)th row. The operation cycle 342 is a compensation cycle for the ith row and is a programming cycle of the (i+1)th row. The operation cycle 344 is a driving cycle for the ith row and is a compensation cycle for the (i+1)th row.] Referring to Figures 20 to 22, during the programming cycle 340 for the ith row of a display, node A4 of the pixel circuit in the ith row is charged to a programming voltage through the switch transistor 308 while the select line. SEL[i] is high. During the programming cycle 342 for the (i+1)th row, SEL[i+1] goes high, and the voltage stored at node A4 changes based on the conductance of the sensor 316. During the driving cycle 344 of the ith row, the current of the drive transistor 306 controls the OLED luminance.

The amount of the discharged voltage at node A4 depends on the conductance of the sensor 316. The sensor 316 is controlled by the OLED luminance or temperature. Thus, the amount of the discharged voltage reduces as the pixel ages. This results in constant luminance over the lifetime of the pixel circuit.

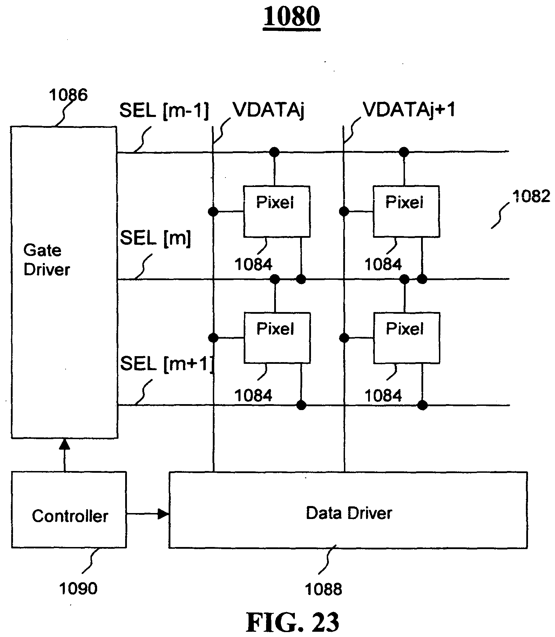

Figure 23 illustrates an example of a display system for the drive circuit 304 of Figures 20 and 21. The display system 1080 of Figure 23 includes a display array 1082 having a plurality of pixels 1084. The pixel 1084 includes the drive circuit 304 of Figures 20 and 21, and may be the pixel circuit 300 of Figure 20 or the pixel circuit 330 of Figure 21.

The display array 1082 is an active matrix light emitting display. In one example, the display array 1082 is an AMOLED display array. The display array 1082 may be a single color, multi-color or a fully color display, and may include one or more than one electroluminescence (EL) element (e.g., organic EL). The display array 1082 may be used in mobiles, personal digital assistants (PDAs), computer displays, or cellular phones.

SEL[i] (i= m-1, m, m+1) in Figure 23 is an address line for the ith row. VDATAn (n=j, j+1) in Figure 23 is a data line for the nth column The address line SEL[i] correspond to the select line SEL[i] of Figures 20 and 21. The data line VDATAn corresponds to VDATA of Figures 20 and 21.

A gate driver 1086 includes an address driver for providing an address signal to each address line to drive them. A data driver 1088 generates a programming data and drives the data line. A controller 1090 controls the drivers 1086 and 1088 to drive the pixels 1084 and implement the in-pixel compensation as described above.

In Figure 23, four pixels 1084 are shown. However, the number of the pixels 1084 may vary in dependence upon the system design, and does not limited to four. In Figure 23, three address lines and two data lines are shown. However, the number of the select lines and the data lines may vary in dependence upon the system design.

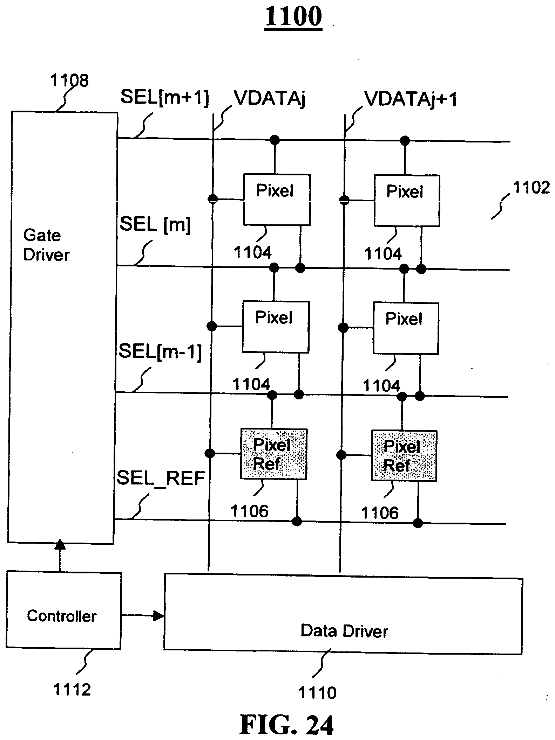

In Figure 23, each of the pixels 1084 includes the sensor 316 of Figures 20 and 21. In another example, the display array 1080 may include one or more than one reference pixel having the sensor 316, as shown in Figure 24.

Figure 24 illustrates another example of a display system for the drive circuit 304 of Figures 20 and 21. The display system 1100 of Figure 24 includes a display array 1102 having a plurality of pixels 1104 and one or more than one reference pixels 1106. The reference pixel 1106 includes the drive circuit 304 of Figures 20 and 21, and may be the pixel circuit 300 of Figure 20 or the pixel circuit 330 of Figure 21. In Figure 24, two reference pixels 1106 are shown. However, the number of the pixels 1084 may vary in dependence upon the system design, and does not limited to two. The pixel 1104 includes an OLED and a drive transistor for driving the OLED, and does not include the sensor 316 of Figures 20 and 21. SEL_REF is a select line for selecting the discharging transistors in the array of the reference pixels 1106.

A gate driver 1108 drives the address lines and the select line SEL_REF. The gate driver 1108 may be same or similar to the gate driver 1108 of Figure 24. A data driver 1110 drives the data lines. The data driver 1110 may be same or similar to the data driver 1088 of Figure 23. A controller 1112 controls the drivers 1108 and 110.

The reference pixels of Figures 23 and 24 (1084 of Figure 23, 1106 of Figure 24) may be operated to provide aging knowledge for an of-panel algorithm in which the programming voltage is calibrated at the controller (1090 of Figure 23, 1112 of Figure 24) or driver side (1088 of Figure 23, 1110 of Figure 24) as described below.

Of-panel calibration is descried in detail. Referring to Figure 21, the of-panel calibration is implemented by extracting the aging of the pixel circuit by reading back the sensor 316, and calibrating the programming voltage. The of-panel calibration compensates for the pixel aging including the threshold Vt shift and OLED degradation.

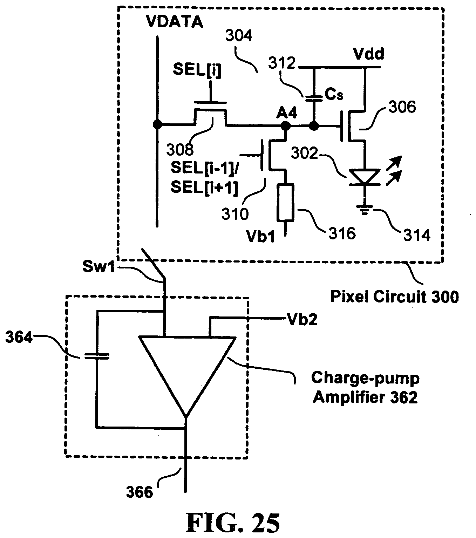

Figure 25 illustrates an example of a pixel system in accordance with an embodiment of the present invention. The pixel system of Figure 25 includes a read back circuit 360. The read back circuit 360 includes a charge-pump amplifier 362 and a capacitor 364. One terminal of the charge-pump amplifier 362 is connectable to the data line VDATA via a switch SW1. The other terminal of the charge-pump amplifier 362 is connected to a bias voltage Vb2. The charge-pump amplifier 362 reads back the voltage discharged from the node A4 via the switch SW1.

The output 366 of the charge pump amplifier 362 varies in dependent upon the voltage at node A4. The time depending characteristics of the pixel circuit is readable from node A4 via the charge-pump amplifier 362.

In Figure 25, one read back circuit 360 and one switch SW1 are illustrated for one pixel circuit. However, the read back circuit 360 and the switch SW1 may be provided for a group of pixel circuits (e.g., pixel circuits in a column). In Figure 25, the read back circuit 360 and the switch SW1 are provided to the pixel circuit 300. In another example, the read back circuit 360 and the switch SW 1 are applied to the pixel circuit 330 of Figure 21.

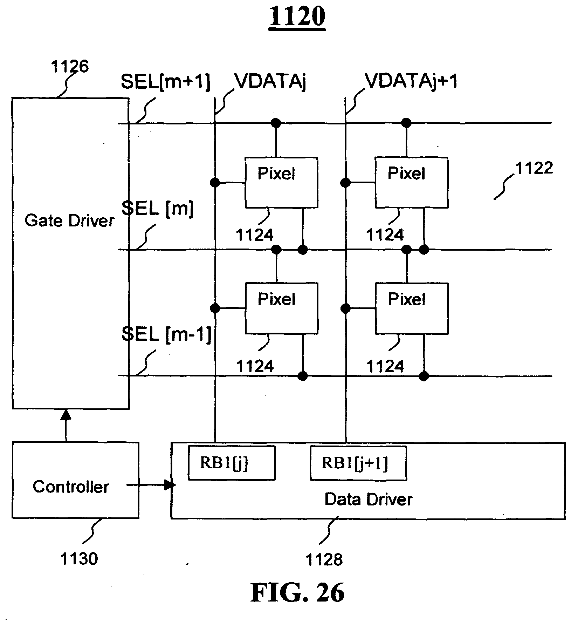

Figure 26 illustrates an example of a display system having the read back circuit 360 of Figure 25. The display system 1120 of Figure 26 includes a display array 1122 having a plurality of pixels 1124. The pixel 1124 includes the drive circuit 304 of Figures 20 and 21, and may be the pixel circuit 300 of Figure 20 or the pixel circuit 330 of Figure 21. The pixel 1124 may be same or similar to the pixel 1084 of Figure 23 or 1106 of Figure 24.

In Figure 26, four pixels 1124 are shown. However, the number of the pixels 1124 may vary in dependence upon the system design, and does not limited to four. In Figure 26, three address lines and two data lines are shown. However, the number of the select lines and the data lines may vary in dependence upon the system design.

For each column, a read back circuit RB1[n] (n=j, j+1) and a switch SW1[n] (not shown) are provided. The read back circuit RB1[n] may include the SW 1[n]. The read back circuit RB1[n] and the switch SW1[n] correspond to the read back 360 and the switch SW1 of Figure 25, respectively. In the description below, the terms RB1 and RB1[n] may be used interchangeably, and RB1 may refer to the read back circuit 360 of Figure 25 for a certain row.

The display array 1122 is an active matrix light emitting display. In one example, the display array 1122 is an AMOLED display array. The display array 1122 may be a single color, multi-color or a fully color display, and may include one or more than one electroluminescence (EL) element (e.g., organic EL). The display array 1122 may be used in mobiles, personal digital assistants (PDAs), computer displays, or cellular phones.

A gate driver 1126 includes an address driver for driving the address lines. The gate driver 1126 may be same or similar to the gate driver 1086 of Figure 23 or the gate driver 1108 of Figure 24. A data driver 1128 generates a programming data and drives the data lines. The data driver 1128 includes a circuit for calculating the programming data based on the output of the corresponding read back circuit RB1(n]. A controller 1130 controls the drivers 1126 and 1128 to drive the pixels 1124 as described above. The controller 1130 controls the switch SW1[n] to turn on or off so that the RB1[n] is connected to the corresponding data line VDATAn..

The pixels 1124 are operated to provide aging knowledge for the of-panel algorithm in which the programming voltage is calibrated at the controller 1130 or driver side 1128 according to the output voltage of the read back circuit RB1. A simple calibration can be scaling in which the programming voltage is scaled up by the change in the output voltage of the read back circuit RB1.

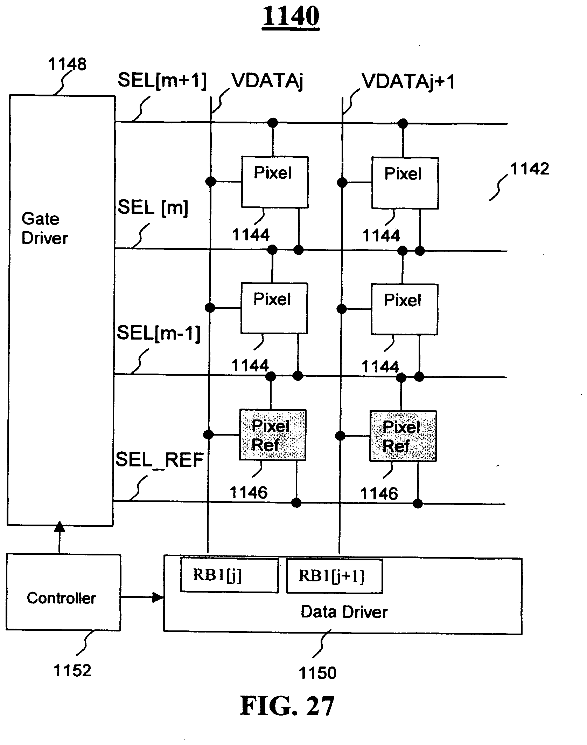

In Figure 26, each of the pixels 1124 includes the sensor 316 of Figures 20 and 21. In another example, the display array 1120 may include one or more than one reference pixel having the sensor 316, as shown in Figure 27.

Figure 27 illustrates another example of a display system having the read back circuit of Figure 25. The display system 1140 of Figure 27 includes a display array 1142 having a plurality of pixels 1144 and one or more than one reference pixels 1146. The reference pixel 1146 includes the drive circuit 304 of Figures 20 and 21, and may be the pixel circuit 300 of Figure 20 or the pixel circuit 330 of Figure 21. In Figure 27, two reference pixels 1146 are shown. However, the number of the pixels 1084 may vary in dependence upon the system design, and does not limited to two. The pixel 1144 includes an OLED and a drive transistor for driving the OLED, and does not include the sensor 316 of Figures 20 and 21. SEL_REF is a select line for selecting the discharging transistors in the array of the reference pixels 1146.

A gate driver 1148 drives the address lines and the select line SEL_REF. The gate driver 1148 may be same or similar to the gate driver 1126 of Figure 26. A data driver 1150 generates a programming data, calibrates the programming data and drives the data lines. The data driver 1150 may be same or similar to the data driver 1128 of Figure 26. A controller 1152 controls the drivers 1148 and 1150.

The reference pixels 1146 are operated to provide aging knowledge for the of-panel algorithm in which the programming voltage is calibrated at the controller 1152 or driver side 1150 according to the output voltage of the read back circuit RB1. A simple calibration can be scaling in which the programming voltage is scaled up by the change in the output voltage of the read back circuit RB1.

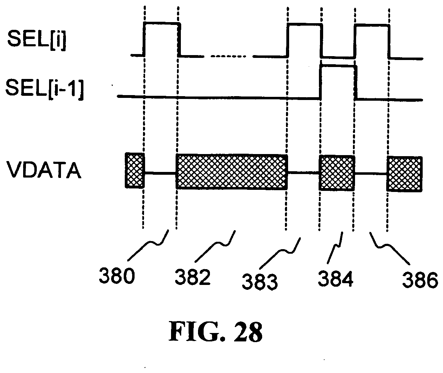

Figure 28 illustrates an example of a method of driving a pixel circuit in accordance with a further embodiment of the present invention. The display system 1120 of Figure 26 and the display system 1140 of Figure 27 are capable of operating according to the waveforms of Figure 28. By applying the waveforms of Figure 28 to the display system having the read back circuit (e.g., 360 of Figure 3, RB1 of Figures 26 and 27), the of-panel calibration is implemented.

The operation cycles of Figure 28 include operation cycles 380, 382, 383, 384, and 386. The operation cycle 380 is a programming cycle for the ith row. The operation cycle 382 is a driving cycle for the ith row. The driving cycle of each row is independent of the other rows. The operation cycle 383 is an initialization cycle for the ith row. The operation cycle 384 is an integration cycle for the ith row. The operation cycle 386 is a read back cycle for the ith row.

Referring to Figures 25 to 28, during the programming cycle 380 for the ith row, node A4 of the pixel circuit in the ith row is charged to a programming voltage through the switch transistor 308 while the select line SEL[i] is high. During the programming cycle 380 for the ith row, node A4 is charged to a calibrated programming voltage. During the driving cycle 382 for the ith row, the OLED luminance is controlled by the driver transistor 306. During the initialization cycle 383 for the ith row, node A4 is charged to a bias voltage. During the integration cycle 384 for the ith row, the SEL[i-1] is high and so the voltage at node A4 is discharged through the sensor 316. During the read back cycle 386, the change in the voltage at node A4 is read back to be used for calibration (e.g. scaling the programming voltage).

At the beginning of the read back cycle 384, the switch SW1 of the read back circuit RB1 is on, and the data line VDATA is charged to Vb2. Also the capacitor 364 is charged to a voltage, Vpre, as a result of leakage contributed from all the pixels connected to the date line VDATA. Then the select line SEL[i] goes high and so the discharged voltage Vdisch is developed across the capacitor 364. The difference between the two extracted voltages (Vpre and Vdisch) are used to calculate the pixel aging.

The sensor 316 can be OFF most of the time and be ON just for the integration cycle 384. Thus, the sensor 316 ages very slightly. In addition, the sensor 316 can be biased correctly to suppress its degradation significantly

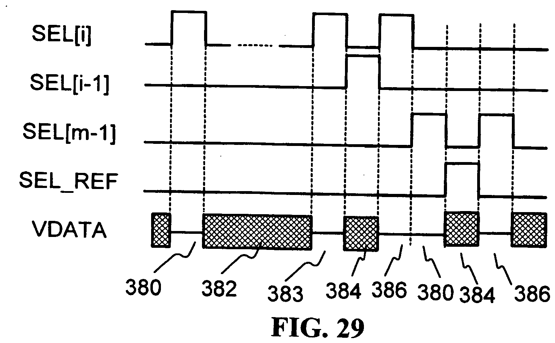

In addition, this method can be used for extracting the aging of the sensor 316. Figure 29 illustrates an example of a method of extracting the aging of the sensor 316. The extracted voltages of the sensors for a dark pixel and a dark reference pixel can be used to find out the aging of the sensor 316. For example, the display system 1140 of Figure 27 is capable of operating according to the waveforms of Figure 29.

The operation cycles of Figure 29 include operation cycles 380, 382, 383, 384, and 386. The operation cycle 380 is a programming cycle for the ith row. The operation cycle 382 is a driving cycle for the ith row. The operation cycle 383 is an initialization cycle for the ith row. The operation cycle 384 is an integration cycle for the ith row. The operation cycle 386 is a read back cycle for the ith row. The operation cycle 380 (the second occurrence) is an initialization for a reference row. The operation cycle 384 (the second occurrence) is an integration cycle for the reference row. The operation cycle 386 (the second occurrence) is a read back cycle (extraction) for the reference row.

The reference row includes one or more reference pixels (e.g., 1146 of Figure 27), and is located in the (m-1)th row. SEL_REF is a select line for selecting the discharging transistors (e.g., 310 of Figure 25) in the reference pixels in the reference row.

Referring to Figures 25, 27 and 29, to extract the aging of the sensor 316, a normal pixel circuit (e.g., 1144) is OFF. The difference between the extracted voltage via the output 316 from the normal pixel and voltage extracted for the OFF state of the reference pixel (e.g., 1146) is extracted. The voltage for the OFF state of the reference pixel is extracted where the reference pixel is not under stress. This difference results in the extraction of the degradation of the sensor 316.

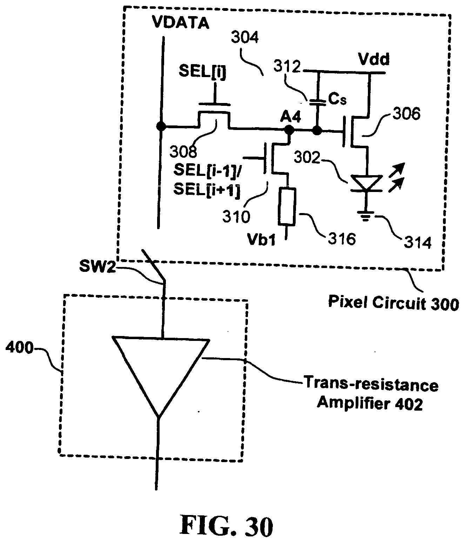

Figure 30 illustrates an example of a pixel system in accordance with another embodiment of the present invention. The pixel system of Figure 30 includes a read back circuit 400. The read-back circuit 400 includes a trans-resistance amplifier 402. One terminal of the trans-resistance amplifier 402 is connectable to the data line VDATA via a switch SW2. The trans-resistance amplifier 402 reads back the voltage discharged from the node A4 via the switch SW2. The switch SW2 may be same or similar to the switch SW1 of Figure 25.

The output of the trans-resistance amplifier 402 varies in dependent upon the voltage at node A4. The time depending characteristics of the pixel circuit is readable from node A4 via the trans-resistance amplifier 402.

In Figure 30, one read back circuit 400 and one switch SW2 are illustrated for one pixel circuit. However, the read back circuit 400 and the switch SW2 may be provided for a group of pixel circuits (e.g., pixel circuits in a column). In Figure 30, the read back circuit 400 and the switch SW2 are provided to the pixel circuit 300. In another example, the read back circuit 400 and the switch SW2 are applied to the pixel circuit 330 of Figure 21.

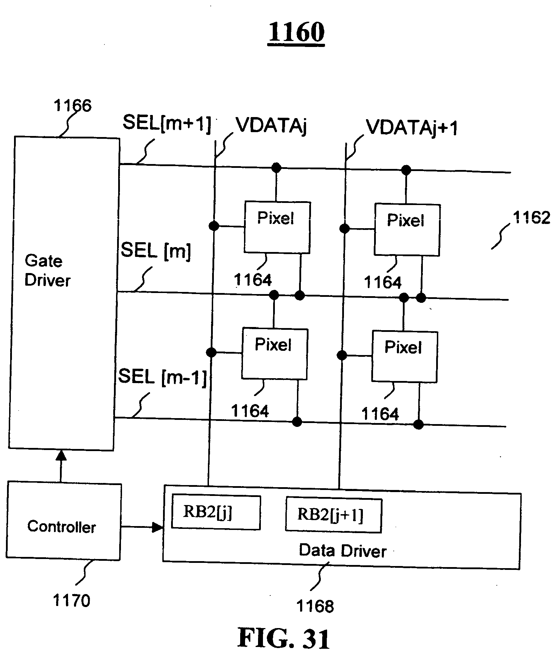

Figure 31 illustrates an example of a display system having the read back circuit 400 of Figures 30. The display system 1160 of Figure 31 includes a display array 1162 having a plurality of pixels 1164. The pixel 1164 includes the drive circuit 304 of Figures 20 and 21, and may be the pixel circuit 300 of Figure 20 or the pixel circuit 330 of Figure 21. The pixel 1164 may be same or similar to the pixel 1124 of Figure 26 or 1146 of Figure 27.

In Figure 31, four pixels 1164 are shown. However, the number of the pixels 1164 may vary in dependence upon the system design, and does not limited to four. In Figure 31, three address lines and two data lines are shown. However, the number of the select lines and the data lines may vary in dependence upon the system design.

For each column, a read back circuit RB2[n] (n=j, j+1) and a switch SW2[n] (not shown) are provided. The read back circuit RB2[n] may include the SW2[n]. The read back circuit RB2[n] and the switch SW2[n] correspond to the read back 400 and the switch SW2 of Figure 30, respectively. In the description below, the terms RB2 and RB2[n] may be used interchangeably, and RB2 may refer to the read back circuit 400 of Figure 30 for a certain row.

The display array 1162 is an active matrix light emitting display. In one example, the display array 1162 is an AMOLED display array. The display array 1162 may be a single color, multi-color or a fully color display, and may include one or more than one electroluminescence (EL) element (e.g., organic EL). The display array 1162 may be used in mobiles, personal digital assistants (PDAs), computer displays, or cellular phones.

A gate driver 1166 includes an address driver for driving the address lines. The gate driver 1166 may be same or similar to the gate driver 1126 of Figure 26 or the gate driver 1148 of Figure 27. A data driver 1168 generates a programming data and drives the data lines. The data driver 1168 includes a circuit for calculating the programming data based on the output of the corresponding read back circuit RB2[n]. A controller 1170 controls the drivers 1166 and 1168 to drive the pixels 1164 as described above. The controller 1170 controls the switch SW2[n] to turn on or off so that the RB2[n] is connected to the corresponding data line VDATAn.

The pixels 1164 are operated to provide aging knowledge for the of-panel algorithm in which the programming voltage is calibrated at the controller 1170 or driver side 1 168 according to the output voltage of the read back circuit RB2. A simple calibration can be scaling in which the programming voltage is scaled up by the change in the output voltage of the read back circuit RB2.

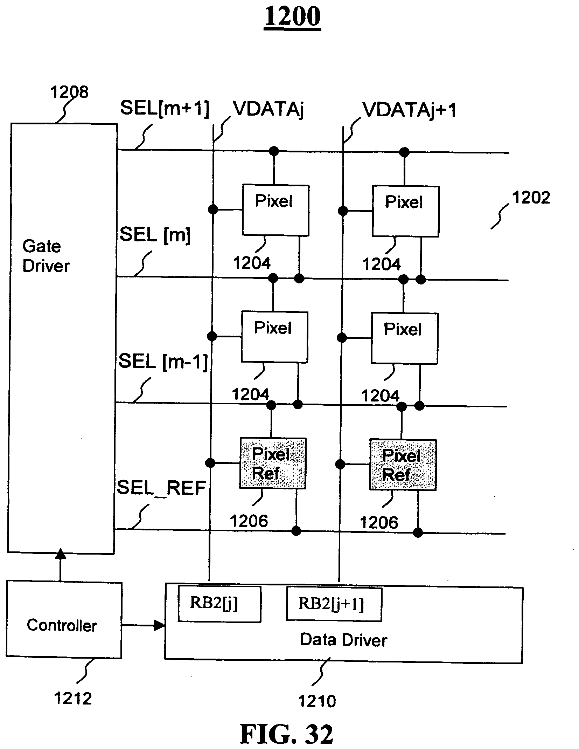

In Figure 31, each of the pixels 1164 includes the sensor 316 of Figures 20 and 21. In another example, the display array 1160 may include one or more than one reference pixel having the sensor 316, as shown in Figure 32.

Figure 32 illustrates another example of a display system having the read back circuit 400 of Figure 30. The display system 1200 of Figure 32 includes a display array 1202 having a plurality of pixels 1204 and one or more than one reference pixels 1206. The reference pixel 1206 includes the drive circuit 304 of Figures 20 and 21, and may be the pixel circuit 300 of Figure 20 or the pixel circuit 330 of Figure 21. In Figure 32, two reference pixels 1206 are shown. However, the number of the pixels 1204 may vary in dependence upon the system design, and does not limited to two. The pixel 1204 includes an OLED and a drive transistor for driving the OLED, and does not include the sensor 316 of Figures 20 and 21. SEL_REF is a select line for selecting the discharging transistors in the array of the reference pixels 1206.

A gate driver 1208 drives the address lines and the select line SEL_REF. The gate driver 1208 may be same or similar to the gate driver 1148 of Figure 27 or the gate driver 1166 of Figure 31. A data driver 1210 generates a programming data, calibrates the programming data and drives the data lines. The data driver 1210 may be same or similar to the data driver 1150 of Figure 27 or the data driver 1168 of Figure 32. A controller 1212 controls the drivers 1208 and 1210.

The reference pixels 1206 are operated to provide aging knowledge for the of-panel algorithm in which the programming voltage is calibrated at the controller 1212 or driver side 1210 according to the output voltage of the read back circuit RB2. A simple calibration can be scaling in which the programming voltage is scaled up by the change in the output voltage of the read back circuit RB2.

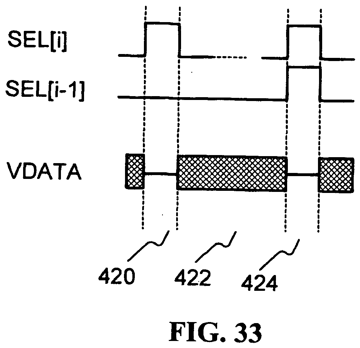

Figure 33 illustrates an example of a method of driving a pixel circuit in accordance with a further embodiment of the present invention. The display system 1160 of Figure 31 and the display system 1200 of Figure 32 are capable of operating according to the waveforms of Figure 33. By applying the waveforms of Figure 33 to the display system having the read back circuit (e.g., 400 of figure 30, RB2 of Figures 31 and 32), the of-panel calibration is implemented.

The operation cycles of Figure 33 include operation cycles 410, 422 and 422 for a row. The operation cycle 420 is a programming cycle for the ith row. The operation cycle 422 is a driving cycle for the ith row. The operation cycle 424 is a read back (extraction) cycle for the ith row

Referring to Figure 30 to 33, during the programming cycle 420 for the ith row, node A4 of the pixel circuit in the ith row is charged to a programming voltage through the switch transistor 308 while the select line SEL[i] is high. During the driving cycle 422 for the ith row, the pixel luminance is controlled by the current of the drive transistor 306. During the extraction cycle 424 for the ith row, SEL [i] and SEL[i-l] are high and the current of the sensor 316 is monitored. The change in this current is amplified by the read back circuit RB2. This change is used to measured the luminance degradation in the pixel and compensate for it by calibrating the programming voltage (e.g. scaling the programming voltage).

At the beginning of the read-back cycle 424, the switch SW2 for the row that the algorithm chooses for calibration is ON while SEL[i] is low. Therefore, the leakage current is extracted as the output voltage of the trans-resistance amplifier 402. The selection of the row can be based on stress history, random, or sequential technique. Next, SEL[i] goes high and so the sensor current related to the luminance or temperature of the pixel is read back as the output voltage of the trans-resistance amplifier 402. Using the two extracted voltages for leakage current and sensor current, one can calculated the pixel aging.

The sensor 316 can be OFF most of the time and be ON just for the operation cycle 424. Thus, the sensor 316 ages very slightly. In addition, the sensor 316 can be biased correctly to suppress its degradation significantly

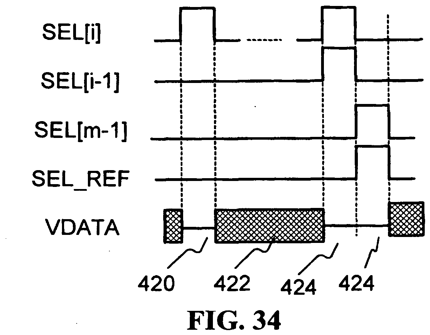

In addition, this method can be used for extracting the aging of the sensor 316. Figure 34 illustrates an example of a method of extracting the aging of the sensor 316 of Figure 30. For example, the display system 1200 of Figure 32 operates according to the waveforms of Figure 34.

The operation cycles of Figure 34 include operation cycles 420, 422 and 424. The operation cycle 420 (the first occurrence) is a programming cycle for the ith row. The operation cycle 422 is a driving cycle for the ith row. The operation cycle 424 (the first occurrence) is a read back (extraction) cycle for the ith row. The operation cycle 424 (the second occurrence) is a read back (extraction) cycle for a reference row.

The reference row includes one or more reference pixels (e.g., 1206 of Figure 32) and is located in the (m-1)th row. SEL_REF is a select line for selecting the discharging transistors (e.g., 310 of Figure 30) in the reference pixels in the reference row.

Referring to Figures 30, 32 and 34, to extract the aging of the sensor 316, a normal pixel circuit (e.g., 1204) is OFF. The difference between the extracted voltage via the output of the trans-resistance amplifier 402 from the normal pixel circuit and voltage extracted for the OFF state of the reference pixel (e.g., 1206) is extracted. The voltage for the OFF state of the reference pixel is extracted where the reference pixel is not under stress. This results in the extraction of the degradation of the sensor 316.

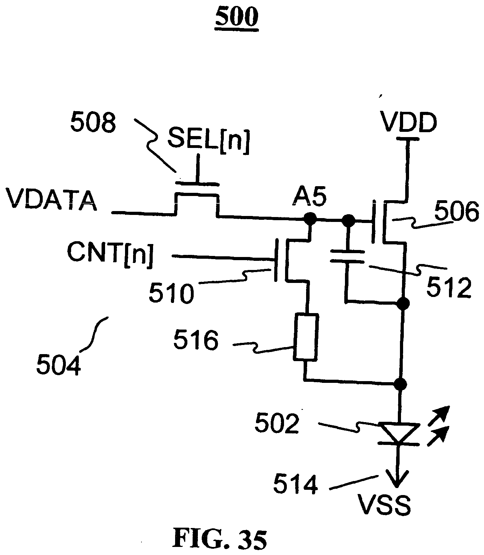

Figure 35 illustrates an example of a pixel circuit to which a pixel drive scheme in accordance with a further embodiment of the present invention. The pixel circuit 500 of Figure 35 includes an OLED 502 and a drive circuit 504 for driving the OLED 502. The drive circuit 504 includes a drive transistor 506, a switch transistor 508, a discharging transistor 510, an adjusting circuit 510, and a storage capacitor 512.

The OLED 502 may be same or similar to the OLED 212 of Figure 13 or the OLED 302 of Figure 20. The capacitor 512 may be same or similar to the capacitor 224 of Figure 13 or the capacitor 312 of Figure 20. The transistors 506, 508 and 510 may be same or similar to the transistors 206,220, and 222 of Figure 13 or the transistors 306, 308 and 310 of Figure 20. In one example, each of the transistors 506, 508 and 510 includes a gate terminal, a source terminal and a drain terminal.

The drive transistor 506 is provided between a voltage supply line VDD and the OLED 502. One terminal (e.g., drain) of the drive transistor 506 is connected to VDD. The other terminal (e.g., source) of the drive transistor 506 is connected to one electrode (e.g., anode electrode) of the OLED 502. The other electrode (e.g., cathode electrode) of the OLED 502 is connected to a power supply line VSS (e.g., common ground) 514. One terminal of the storage capacitor 512 is connected to the gate terminal of the drive transistor 506 at node A5. The other terminal of the storage capacitor 512 is connected to the OLED 502. The gate terminal of the switch transistor 508 is connected to a select line SEL [n]. One terminal of the switch transistor 508 is connected to data line VDATA. The other terminal of the switch transistor 508 is connected to node A5. The gate terminal of the transistor 510 is connected to a control line CNT[n]. In one example, n represents the nth row in a display array. One terminal of the transistor 510 is connected to node A5. The other terminal of the transistor 510 is connected to one terminal of the adjusting circuit 516. The other terminal of the adjusting circuit 516 is connected to the OLED 502.

The adjusting circuit 516 is provided to adjust the voltage of A5 with the discharging transistor 510 since its resistance changes based on the pixel aging. In one example, the adjusting circuit 516 is the transistor 218 of Figure 13. In another example, the adjusting circuit 516 is the sensor 316 of Figure 20.

To improve the shift in the threshold voltage of the drive transistor 506, the pixel circuit is turned off for a portion of frame time.

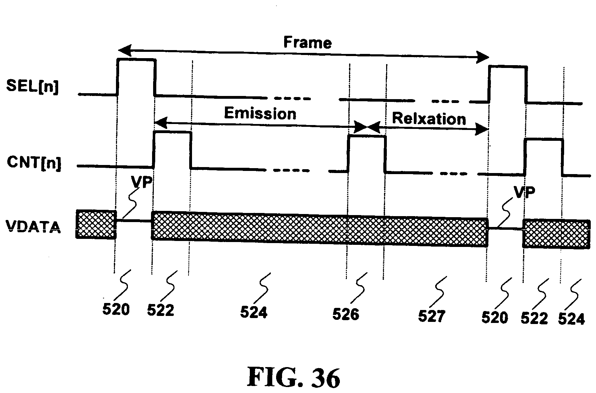

Figure 36 illustrates an example of a method of driving a pixel circuit in accordance with a further embodiment of the invention. The waveforms of Figure 36 are applied to the pixel circuit of Figure 35. The operation cycles for the pixel circuit 500 include a programming cycle 520, a discharge cycle 522, an emission cycle 524, a reset cycle 526, and a relaxation cycle 527.

During the programming cycle 520, node A5 is charged to a programming voltage VP. During the discharge cycle 522, CNT[n] goes high, and the voltage at node A5 is discharge partially to compensate for the aging of the pixel. During the emission cycle 524, SEL[n] and CNT[n] go low. The OLED 502 is controlled by the drive transistor 506 during the emission cycle 524. During the reset cycle 526, the CNT[n] goes to a high voltage so as to discharge the voltage at node A5 completely during the reset cycle 526. During the relaxation cycle 527, the drive transistor 506 is not under stress and recovers from the emission 524. Therefore, the aging of the drive transistor 506 is reduced significantly.

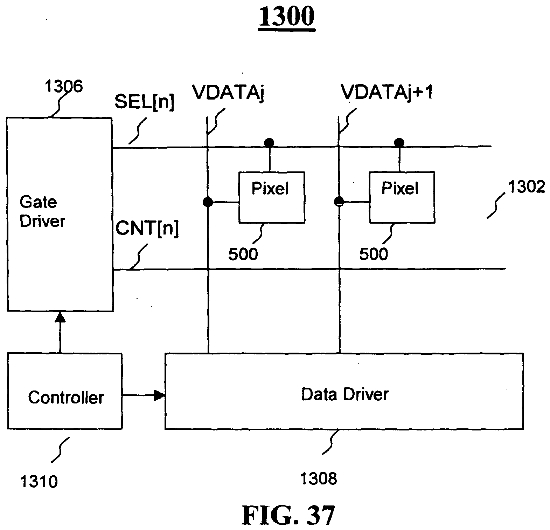

Figure 37 illustrates an example of a display system including the pixel circuit of Figure 35. The display system 1300 of Figure 37 includes a display array 1302 having a plurality of pixels 500. The display array 1302 is an active matrix light emitting display. In one example, the display array 1302 is an AMOLED display array. The pixels 500 are arranged in rows and columns. In Figure 37, two pixels 500 for the nth row are shown. The display array 1302 may include more than two pixels.

The display array 1302 may be a single color, multi-color or a fully color display, and may include one or more than one electroluminescence (EL) element (e.g., organic EL). The display array 1302 may be used in mobiles, personal digital assistants (PDAs), computer displays, or cellular phones.

Address line SEL[n] is proved to the nth row. Control line CNT[n] is proved to the nth row. Data line VDATAk (k=j, j+1) is proved to the kth column. The address line SEL[n] corresponds to SEL[n] of Figure 35. The control line CNT[n] corresponds to CNT[n] of Figure 35. The data Line VDATAk (k=j, j+1) corresponds to VDATA of Figure 35.

A gate driver 1306 drives SEL[n]. A data driver 1308 generates a programming data and drives VDATAk. A controller 1310 controls the drivers 1306 and 1308 to drive the pixels 500 to produce the waveforms of Figure 36.

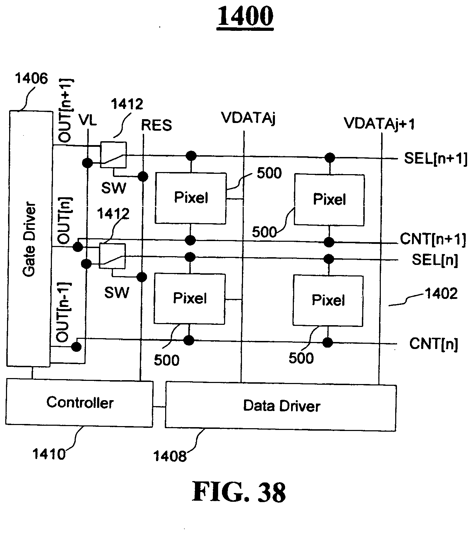

Figure 38 illustrates another example of a display system including the pixel circuit 500 of Figure 35. The display system 1400 of Figure 38 includes a display array 1402 having a plurality of pixels 500. The display array 1402 is an active matrix light emitting display. In one example, the display array 1302 is an AMOLED display array. The pixels 500 are arranged in rows and columns. In Figure 38, four pixels 500 for the nth row are shown. The display array 1402 may include more than four pixels.

SEL[i] (i=n, n+1) is a select line and corresponds to SEL[n] of Figure 35. CNT[i] (i=n, n+1) is a control line and corresponds to CNT[n] of Figure 35. OUT[k] (k=n-1, n, n+1) is an output from a gate driver 1406. The select line is connectable to one of the outputs from the gate driver 1402 or VL line. VDATAm (m=j, j+1) is a data line and corresponds to VDATA of Figure 35. VDATAm is controlled by a data driver 1408. A controller 1410 controls the gate driver 1406 and the data driver 1408 to operate the pixel circuit 500.

The control lines and select lines share the same output from the gate driver 1406 through switches 1412. During the discharge cycle 526 of Figure 36, RES signal changes the switches 1412 direction and connect the select lines to the VL line which has a low voltage to turn off the transistor 508 of the pixel circuit 500. OUT[n-1] is high and so CNT[n] is high. Thus the voltage at node A5 is adjusted by the adjusting circuit 516 and discharging transistor 510. During other operation cycles, RES signal and switches 1412 connect the select lines to the corresponding output of the gate driver (e.g., SEL[n] to OUT[n]). The switches 1412 can be fabricated on the panel using the panel fabrication technology (e.g. amorphous silicon) or it can be integrated inside the gate driver.

According to the embodiments of the present invention, the drive circuit and the waveforms applied to the drive circuit provide a stable AMOLED display despite the instability of backplane and OLED. The drive circuit and its waveforms reduce the effects of differential aging of the pixel circuits. The pixel scheme in the embodiments does not require any additional driving cycle or driving circuitry, resulting in a row cost application for portable devices including mobiles and PDAs. Also it is insensitive to the temperature change and mechanical stress, as it would be appreciated by one of ordinary skill in the art.

One or more currently preferred embodiments have been described by way of examples as described above. It will be apparent to persons skilled in the art that a number of variations and modifications can be made without departing from the scope of the invention as defined in the claims.

### Further comparative examples for understanding the present invention are described below.

In accordance to a first example, it is provided a display system, comprising: a drive circuit for a pixel having a light emitting device, comprising: a drive transistor connected to the light emitting device, the drive transistor including a gate terminal, a first terminal and a second terminal; a first transistor including a gate terminal, a first terminal and a second terminal, the gate terminal of the first transistor being connected to a select line, the first terminal of the first transistor being connected to a data line, the second terminal of the first transistor being connected to the gate terminal of the drive transistor; a circuit for adjusting the gate voltage of the drive transistor, the circuit including a discharging transistor having a gate terminal, a first terminal and a second terminal, the gate terminal of the discharging transistor being connected to the gate terminal of the drive transistor at a node, the voltage of the node being discharged through the discharging transistor; and a storage capacitor including a first terminal and a second terminal, the first terminal of the storage capacitor being connected to the gate terminal of the drive transistor at the node.

According to a second example, the first terminal of the drive transistor, or a combination of the second terminal of the drive transistor, the second terminal of the discharging transistor and the second terminal of the storage capacitor is connected to the light emitting device.

According to a third example, the first terminal of the discharging transistor is connected to the gate terminal of the drive transistor.

According to a fourth example, the circuit for adjusting comprises a second transistor having a gate terminal, a first terminal and a second terminal, the gate terminal of the second transistor being connected to a bias line, the first terminal of the second transistor being connected to the gate terminal of the drive transistor, the second terminal of the second transistor being connected to the first terminal of the discharging transistor.

According to a fifth example, the circuit for adjusting comprises a second transistor having a gate terminal, a first terminal and a second terminal, the gate terminal and the first terminal of the second transistor being connected to the gate terminal of the drive transistor, the second terminal of the second transistor being connected to the first terminal of the discharging transistor.

According to a sixth example, the circuit for adjusting comprises a resistor element having a first terminal and a second terminal, the first terminal of the resistor element being connected to the gate terminal of the drive transistor, the second terminal of the resistor element being connected to the first terminal of the discharging transistor.

According to a seventh example, the light emitting device comprises a first electrode, a second electrode, and an emission layer between the first electrode and the second electrode, and wherein the first terminal of the drive transistor is connected to one of the first electrode and the second electrode, and wherein the second terminal of the drive transistor, the second terminal of the discharging transistor and the second terminal of the storage capacitor are connected to a power supply.

According to an eighth example, the light emitting device comprises a first electrode, a second electrode, and an emission layer between the first electrode and the second electrode, and wherein the second terminal of the drive transistor, the second terminal of the discharging transistor and the second terminal of the storage capacitor are connected to one of the first electrode and the second electrode, and wherein the first terminal of the drive transistor is connected to a power supply.

According to a ninth example, the drive circuit is formed in amorphous, poly, n-type, p-type, CMOS, microcrystalline, nanocrystalline, crystalline silicon or combinations thereof.

According to a tenth example, the display system further comprises a display array including a plurality of pixel circuits arranged in rows and columns, each of the pixel circuits including the drive circuit, and a driver for driving the display array.

Further to the fourth example, the display system comprises a display array including a plurality of pixel circuits arranged in rows and columns, each of the pixel circuits including the drive circuit, and a driver for driving the display array, the bias line being shared by more than one pixel circuit of the plurality of pixel circuits.

According to an twelfth example, the bias line for a row is an adjacent address line for selecting an adjacent row.

According to a thirteenth example, it is a provided a method for a display system according to the eleventh example, wherein the driver provides a programming cycle, a compensation cycle and a driving cycle for each row, at the programming cycle for a first row, selecting the address line for the first row and providing programming data to the first row, at the compensation cycle for the first row, selecting the adjacent address line for a second row adjacent to the first row and disenabling the address line for the first row, and at the driving cycle for the first row, disenabling the adjacent address line.

According to a fourteenth example, at least the compensation cycle for the first row overlaps with the programming cycle for the second row.

According to a fifteenth example, it is provided a display system, comprising: one or more than one pixel circuit, each including a light emitting device and a drive circuit, the drive circuit including: a drive transistor including a gate terminal, a first terminal and a second terminal, the drive transistor being between the light emitting device and a first power supply; a switch transistor including a gate terminal, a first terminal and a second terminal, the gate terminal of the switch transistor being connected to a first address line, the first terminal of the switch transistor being connected to a data line, the second terminal of the switch transistor being connected to the gate terminal of the drive transistor; a circuit for adjusting the gate voltage of the drive transistor, the circuit including a sensor for sensing energy transfer from the pixel circuit and a discharging transistor, the sensor having a first terminal and a second terminal, a property of the sensor varying in dependence upon the sensing result, the discharging transistor having a gate terminal, a first terminal and a second terminal, the gate terminal of the discharging transistor being connected to a second address line, the first terminal of the discharging transistor being connected to the gate terminal of the drive transistor at a node, the second terminal of the discharging transistor being connected to the first terminal of the sensor; and a storage capacitor including a first terminal and a second terminal, the first terminal of the storage capacitor being connected to the gate terminal of the drive transistor at the node.

According to a sixteenth example, the second terminal of the sensor is connected to a power supply or one of the first terminal and the second terminal of the drive transistor.

Further to the fifteenth or the sixteenth example, the sensor senses a temperature of the pixel circuit.

Further to the fifteenth or the sixteenth example, the sensor senses a luminance of the pixel circuit.

According to a nineteenth example, the first address line is an address line for a first row in a display array, and wherein the second address line is an address line for a second row adjacent to the first row.

Further to the nineteenth example, the display system further comprises a driver for implementing an in-pixel compensation.

According to a twenty-first example, it is provided a display system according to the twentieth example, wherein the driver provides a programming cycle, a compensation cycle and a driving cycle for each row, at the programming cycle for a first row, selecting the address line for the first row and providing programming data to the first row, at the compensation cycle for the first row, selecting the adjacent address line for a second row adjacent to the first row and disenabling the address line for the first row, and at the driving cycle for the first row, disenabling the adjacent address line.

According to a twenty-second example, the display system according to any one of the fifteenth to nineteenth examples, further comprises at least one read back circuit for reading back the sensor to calibrate the programming data.

According to a twenty-third example, the display system of the twenty-second example further comprises a driver including a first driver for generating the programming data in dependence upon the result of the reading back and a second driver for selecting a row.

According to a twenty-fourth example, in the display system of the twenty-third example the driver implements an of-pixel compensation for calibrating the programming data based on the reading back result.

According to a twenty-fifth example, in the display system according to the twenty-fourth example, the at least one read back circuit comprises a charge pump amplifier including a first input, a second input and an output, and a capacitor connected between the first input and the output, and wherein the first input is connectable to the corresponding data line via a switch and the second input is connected to a bias line.

According to a twenty-sixth example, in the display system according to the twenty-fourth example, the at least one read back circuit comprises a trans-resistance amplifier including an input and an output, and wherein the input of the trans resistance amplifier is connectable to the corresponding data line via a switch.

According to a twenty-seventh example, it is provided a method for a display system according to the twenty-fifth example wherein the of-panel compensation including first, second, third, fourth and fifth operation cycles, at the first operation cycle for a first row, selecting the first address line for the first row and programming the pixel circuits in the first row; at the second operation cycle for the first row, disenabling the first address line for the first row and driving the pixel circuits in the first row; at the third operation cycle for the first row, selecting the first address line for the first row and charging the voltage at the node to a bias voltage; at the fourth operation cycle for the first row, selecting the adjacent address line for a second row adjacent to the first row and disenabling the first address line for the first row to discharge the voltage at the node from the sensor; and at the fifth operation cycle for the first row, reading back the change in the voltage at the node from the sensor by selecting the first address line for the first row.

According to the twenty-eighth example, it is provided a method for a display system according to example twenty-six, wherein the of-panel compensation including first, second, and third operation cycles, at the first operation cycle for a first row, selecting the first address line for the first row and programming the pixel circuits in the first row, at the second operation cycle for the first row, disenabling the address line for the first row and driving the pixel circuits in the first row; and at the third operation cycle for the first row, monitoring the output from the sensor by selecting the address line for the first row and the adjacent address line for a second row adjacent to the first row.

According to the twenty-ninth example, in the display system according to examples twenty-three or twenty-four, the one or more than one pixel is one or more than one reference pixel circuit for one or more than one second pixel circuit, and wherein the read back operation is applied to the one or more than one reference pixel circuit to calibrate the programming data for the second pixel circuit.

According to a thirtieth example, in the display system of the twenty-ninth example, the driver reads back the aging of the sensor based on the output from the reference pixel circuit.

According to a thirty-first example, it is provided a display system, comprising: a display array including a plurality of pixel circuits arranged in rows and columns, each including a light emitting device and a drive circuit; and a drive system for driving the display array, the drive circuit including: a drive transistor including a gate terminal, a first terminal and a second terminal, the drive transistor being between the light emitting device and a first power supply; a first transistor including a gate terminal, a first terminal and a second terminal, the gate terminal of the first transistor being connected to an address line, the first terminal of the first transistor being connected to a data line, the second terminal of the first transistor being connected to the gate terminal of the drive transistor; a circuit for adjusting the gate voltage of the drive transistor, the circuit including a second transistor, the second transistor having a gate terminal, a first terminal and a second terminal, the gate terminal of the second transistor being connected to a control line, the first terminal of the second transistor being connected to the gate terminal of the drive transistor; and a storage capacitor including a first terminal and a second terminal, the first terminal of the storage capacitor being connected to the gate terminal of the drive transistor, the drive system driving the pixel circuit so that the pixel circuit is turned off for a portion of a frame time.

According to a thirty-second example, the circuit may comprise a third transistor connected between the second transistor and the light emitting device, the resistance of the third transistor being changed in dependence upon the aging of the pixel circuit.

According to a thirty-third , the circuit may comprise a sensor having a resistance which varies in dependence upon the aging of the pixel circuit.

Further to the method for a display system according to the thirty-first example, the drive system provides a frame time having a programming cycle, a discharge cycle, an emission cycle, a reset cycle, and a relaxation cycle, for each row, at the programming cycle, programming the pixel circuits on the row by activating the address line for the row; at the discharge cycle, partially discharging the voltage on the gate terminal of the drive transistor by deactivating the address line for the row and activating the control line for the row; at the emission cycle, deactivating the control line for the row, and controlling the light emitting device by the drive transistor; at the reset cycle, discharging the voltage on the gate terminal of the drive transistor by activating the control line for the row; and at the relaxation cycle, deactivating the control line for the row.

Further to the thirty-first , the driver system comprises a first driver having a drive output for each row, a second driver for driving the data line for each column, and a switch for each row, the address line for a row being selectively connected to the corresponding drive output of the first driver or a voltage line having a predetermined voltage level by the corresponding switch.

Further to the thirty-first example, the control line for the row is connected to a drive output different from that of the address line for the row.

## Claims

1. A display system, comprising:
a pixel circuit (300; 330) comprising a light emitting device (302; 332) adapted to emit light according to programming data, the pixel circuit (300; 330) further including:
a drive transistor (306) connected in series to the light emitting device (302; 332), the drive transistor (306) including a gate terminal, a first terminal and a second terminal;
a first switch transistor (308) adapted to selectively connect a data line to the gate terminal of the drive transistor (306), the first switch transistor (308) including a gate terminal, a first terminal and a second terminal, the programming data being provided on the data line during a programming cycle while the first switch transistor (308) is turned on;
a storage capacitor (310) adapted to control a voltage difference between the gate terminal and the first terminal of the drive transistor (306); and
a circuit adapted to adjust a gate voltage of the drive transistor (306), the circuit comprising a sensor (316) adapted to detect energy transfer from the pixel circuit (300; 330) and a discharging transistor (310) adapted to selectively couple the sensor (316) to the gate terminal of the drive transistor (306), wherein the sensor (316) has a conductance that varies upon a sensing result, and the gate terminal of the drive transistor (306) is discharged through the sensor (316) in dependence upon the conductance of the sensor (316);
wherein the sensor (316) is a thermal or optical sensor having a carrier density that changes based on the absorption of thermal or optical energy from the pixel circuit (300; 330), respectively, such that the resistance of the sensor (316) varies according to the absorbed energy.

2. A display system according to claim 1, wherein the discharging transistor (310) is in series with the sensor (316).

3. The display system according to claim 1, wherein:
the gate terminal of the first switch transistor (308) being connected to a first select line (SEL[i]) for operating the first switch transistor (308), the first terminal of the first switch transistor (308) being connected to the data line providing a programming voltage according to the programming data during the programming cycle, the second terminal of the first switch transistor (308) being connected to the gate terminal of the drive transistor (306);
the storage capacitor (310) including a first terminal and a second terminal, the first terminal being connected to the gate terminal of the drive transistor (306) and the second terminal being connected to the first terminal of the drive transistor (306), the storage capacitor (310) being arranged to be charged according to the programming data during the programming cycle;
the sensor (316) adjusts the gate voltage of the drive transistor (306) by at least partially discharging the voltage on the storage capacitor (310) through the sensor (316) during a compensation cycle following the programming cycle;
the discharging transistor (310) being operated according to a second select line (SEL[i-1]; SEL[i+1]) and connected in series between the gate terminal of the drive transistor (306) and the sensor (316); and
a controller for operating the data line, the first select line (SEL[i]) and the second select line (SEL[i+1]; SEL[i-1]) such that:
the programming voltage is provided on the data line during the programming cycle while the first switch transistor (308) is turned on;
the voltage on the storage capacitor (310) is at least partially discharged through the sensor (316) and the discharging transistor (310) by operating the second select line (SEL[i-1]; SEL[i+1]) to turn on the discharging transistor (310) during said compensation cycle following the programming cycle while the first switch transistor (308) is turned off; and
the drive transistor (306) controls the light emitting device (302; 332) during a driving cycle following the compensation cycle by operating the second select line (SEL[i-1]; SEL[i+1]) to turn off the discharging transistor (310).

4. The display system according to claim 2 or 3, wherein
the light emitting device (302; 332) is an organic light emitting diode and the pixel circuit (130; 300; 330) includes at least one thin film transistor.

5. The display system according to any one of claims 3 or 4, wherein the pixel circuit (300; 330) is a first pixel circuit (300; 330) in a plurality of similar pixel circuits in a display array arranged in rows and columns and wherein the second select line (SEL[i-1]; SEL[i+1]) is a first select line for a second pixel circuit (300; 330) in the display array situated in a row adjacent to a row including the first pixel circuit (300; 330), such that operating the controller to select the second select line (SEL[i-1]; SEL[i+1]) allows the compensation cycle to occur in the first pixel circuit (300; 330) simultaneously with the programming cycle in the second pixel circuit (300; 330).

6. The display system according to claim 1, further comprising a read back circuit (360) for detecting an aging of the pixel circuit (300; 330) by reading the voltage remaining on the gate terminal of the drive transistor (306) following the compensation cycle, said aging of the pixel circuit (300, 330) including aging of the drive transistor (306) and of the light emitting device (302; 332), wherein a controller is further configured to operate the read back circuit to detect the aging of the pixel circuit (300; 330) and, responsive to the detection of the aging of the pixel circuit (300; 330), calibrate programming voltages provided via the data line according to the detection of the aging;
wherein the read back circuit includes a charge-pump amplifier (362) connectable to the data line via a switch (SW1) for reading back the voltage on the gate terminal of the drive transistor (306) and providing an output to the controller that is indicative of the aging of the pixel circuit (300; 330), and a capacitor (364), and
wherein the charge-pump amplifier (362) has a first terminal connected to the switch (SW1) and a second terminal connected to a bias voltage (Vb2), the capacitor (364) being connected between the first terminal and the output (366) of the charge pump amplifier (362), the output (366) of the charge pump amplifier (362) varying dependent upon the voltage at the gate terminal of the drive transistor (306).

7. The display system according to claim 1 or 2, further comprising: a read back circuit for detecting an aging of the pixel circuit (300; 330) by reading the voltage remaining on the gate terminal of the drive transistor (306) following a driving cycle that follows the programming cycle, said aging of the pixel circuit (300, 330) including aging of the drive transistor (306) and of the light emitting device (302; 332); and
a controller configured to operate the read back circuit to detect the aging of the pixel circuit (300; 330) and, responsive to the detection of the aging of the pixel circuit (300; 330), calibrate programming voltages provided via the data line according to the detection of the aging;
wherein the read back circuit includes a trans-resistance amplifier (402) connectable to the data line via a switch (SW2) for reading back the voltage on the gate terminal of the drive transistor (306) and providing an output to the controller indicative of the aging of the pixel circuit (300; 330), and
wherein the trans-resistance amplifier (402) has an output that varies dependent upon the voltage at the gate terminal of the drive transistor (306).

8. The display system according to claim 6, wherein the read back circuit detects the aging of the pixel circuit (300; 330) by comparing a voltage on the gate terminal of the drive transistor (306) prior to the compensation cycle and a voltage remaining on the gate terminal of the drive transistor (306) following the compensation cycle, the difference between the compared voltages being used in the controller to calculate the aging of the pixel circuit (300; 330).

9. The display system according to claim 8, wherein the controller is configured to calibrate the programming voltages by scaling the programming voltages according to the difference between the compared voltages measured by the read back circuit.

10. The display system according to claim 6, wherein the pixel circuit (300; 330) is a reference pixel circuit (300; 330) in a display array arranged in rows and columns, the display array including a plurality of pixel circuits not including a sensor (316) for detecting aging of the pixel circuits, and wherein the controller operates the read back circuit to calibrate the programming voltages of the plurality of pixel circuits not including the sensor (316) according to the detection of the aging of the reference pixel circuit (300; 330).

11. The display system according to claim 6, wherein the controller is further configured to operate the second select line (SEL[i-1]; SEL[i+1]), the first select line (SEL[i]), the data line, and the read back circuit such that:
the luminance of the light emitting device (302; 332) emits is controlled by the drive transistor (306) during a driving cycle (382) following the programming cycle, the first switch transistor (308) being turned off during the driving cycle,
a bias voltage is provided on the data line during an initialization cycle (383) following the driving cycle while the first switch transistor (308) is turned on to charge the storage capacitor (310) according to the bias voltage,
the compensation cycle (384) is carried out following the initialization cycle while the discharging transistor (310) is turned on and the first switch transistor (308) is turned off to allow the bias voltage on the storage capacitor (310) to at least partially discharge through the discharging transistor (310) and the sensor (316), and
the voltage remaining on the gate terminal of the drive transistor (306) following the compensation cycle being read by the read back circuit, via the data line, during a read back cycle (386) following the compensation cycle while the discharging transistor (310) is turned off and the first switch transistor (308) is turned on.

12. A method for operating a display system including a pixel circuit (300; 330) comprising a light emitting device (302; 332) adapted to emit light according to programming information, the pixel circuit (300; 330) further including:
a drive transistor (306) connected in series to the light emitting device (302; 332), the drive transistor (306) including a gate terminal, a first terminal and a second terminal;
a first switch transistor (308) adapted to selectively connect a data line to the gate terminal of the drive transistor (306), the first switch transistor (308) including a gate terminal, a first terminal, and a second terminal, the programming data being provided on the data line during a programming cycle while the first switch transistor (308) is turned on;
a storage capacitor (310) adapted to control a voltage difference between the gate terminal and the first terminal of the drive transistor (306); and
a circuit configured to adjust a gate voltage of the drive transistor (306), the circuit comprising a sensor (316) adapted to detect energy transfer from the pixel circuit (300; 330) and a discharging transistor (310) adapted to selectively couple the sensor (316) to the gate terminal of the drive transistor (306), wherein the sensor (316) has a conductance that varies upon a sensing result, and the gate terminal of the drive transistor (306) is discharged through the sensor (316) in dependence upon the conductance of the sensor (316), wherein the sensor (316) is a thermal or optical sensor having a carrier density that changes based on the absorption of thermal or optical energy from the pixel circuit (300; 330), respectively, such that the resistance of the sensor (316) varies according to the absorbed energy;
the method comprising:
applying a programming voltage according to programming data on the data line during a programming cycle while the first switch transistor (308) is turned on such that the storage capacitor (310) is charged according to the programming voltage;
adjusting a gate voltage of the drive transistor (306) with the circuit following the programming cycle by operating the discharging transistor (310) to connect the sensor (316) to the gate terminal of the drive transistor (306) such that the gate terminal of the drive transistor (306) is discharged through the sensor (316) in dependence upon the conductance of the sensor (316);
controlling the light emitting device (302; 332) during a driving cycle following the adjustment of the gate voltage of the drive transistor (306) by turning off the discharging transistor (310).

13. The method according to claim 12, the method further comprising:
applying a second programming voltage to the data line for a second pixel circuit (300; 330) having a switch transistor operated by the second select line (SEL[i-1]; SEL[i+1]) to connect a storage capacitor (310) in the second pixel circuit (300; 330) to the data line and thereby simultaneously program the second pixel circuit (300; 330) according to the second programming voltage while a compensation cycle is carried out in the first pixel circuit (300; 330).

14. A method for operating a display system including a pixel circuit (300; 330) comprising a light emitting device (302; 332) adapted to emit light according to programming information, the pixel circuit (300; 330) further including:
a drive transistor (306) connected in series to the light emitting device (302; 332), the drive transistor (306) including a gate terminal, a first terminal and a second terminal;
a first switch transistor (308) adapted to selectively connect a data line to the gate terminal of the drive transistor (306), the first switch transistor (308) including a gate terminal, a first terminal, and a second terminal, the programming data being provided on the data line during a programming cycle while the first switch transistor (308) is turned on;
a storage capacitor (310) adapted to control a voltage difference between the gate terminal and the first terminal of the drive transistor (306);
a circuit configured to adjust a gate voltage of the drive transistor (306), the circuit comprising a sensor (316) adapted to detect energy transfer from the pixel circuit (300; 330) and a discharging transistor (310) adapted to selectively couple the sensor (316) to the gate terminal of the drive transistor (306), wherein the sensor (316) has a conductance that varies upon a sensing result, and the gate terminal of the drive transistor (306) is discharged through the sensor (316) in dependence upon the conductance of the sensor (316), wherein the sensor (316) is a thermal or optical sensor having a carrier density that changes based on the absorption of thermal or optical energy from the pixel circuit (300; 330), respectively, such that the resistance of the sensor (316) varies according to the absorbed energy; and
a read back circuit connected to the pixel circuit (300; 330) via the data line,
the method comprising:
applying a programming voltage according to programming data on the data line during a programming cycle while the first switch transistor (308) is turned on such that the storage capacitor (310) is charged according to the programming voltage;
controlling the light emitting device (302; 332) by the driver transistor (306) during a driving cycle following the programming cycle;
charging the gate terminal of the drive transistor (306) to a bias voltage during an initialization cycle following the driving cycle;
adjusting a gate voltage of the drive transistor (306) with the circuit during an integration cycle following the initialization cycle by operating the discharging transistor (310) to connect the sensor (316) to the gate terminal of the drive transistor (306) such that the gate terminal of the drive transistor (306) is discharged through the sensor (316) in dependence upon the conductance of the sensor (316);
detecting an aging of the pixel circuit (300; 330) by reading the voltage remaining on the gate terminal of the drive transistor (306) following the integration cycle, via the read back circuit, said aging of the pixel circuit (300, 330) including aging of the drive transistor (306) and of the light emitting device (302; 332); and
calibrating the programming voltages provided on the data line according to the detected aging.

15. The method according to claim 14, wherein the calibrating the programming voltages includes:
comparing a voltage on the gate terminal of the drive transistor (306) prior to the integration cycle and a voltage remaining on the gate terminal of the drive transistor (306) following the integration cycle;
calculating the aging of the pixel circuit (300; 330) based on the difference between the compared voltages; and
scaling the programming voltages applied to the data line according to the calculated aging.

## Patentansprüche

1. Displaysystem, mit:
einer Pixelschaltung (300; 330) mit einer lichtemittierenden Einrichtung (302; 332), die ausgebildet ist, Licht gemäß Programmierdaten auszusenden, wobei die Pixelschaltung (300; 330) ferner aufweist:
einen Ansteuertransistor (306), der mit der lichtemittierenden Einrichtung (302; 332) in Reihe geschaltet ist, wobei der Ansteuertransistor (306) einen Gate-Anschluss, einen ersten Anschluss und einen zweiten Anschluss aufweist;
einen ersten Schalttransistor (308), der ausgebildet ist, eine Datenleitung selektiv mit dem Gate-Anschluss des Ansteuertransistors (306) zu verbinden, wobei der Schalttransistor (308) einen Gate-Anschluss, einen ersten Anschluss und einen zweiten Anschluss aufweist, wobei die Programmierdaten auf der Datenleitung während eines Programmierzyklus bereitgestellt werden, während der erste Schalttransistor (308) eingeschaltet ist;
einen Speicherkondensator (310), der ausgebildet ist, eine Spannungsdifferenz zwischen dem Gate-Anschluss und dem ersten Anschluss des Ansteuertransistors (306) zu steuern; und
eine Schaltung, die ausgebildet ist, eine Gate-Spannung des Ansteuertransistors (306) einzustellen, wobei die Schaltung einen Sensor (316), der ausgebildet ist, eine Energieübertragung aus der Pixelschaltung (300; 330) zu erfassen, und einen Entladetransistor (310) aufweist, der ausgebildet ist, selektiv den Sensor (316) mit dem Gate-Anschluss des Ansteuertransistors (306) zu verbinden, wobei der Sensor (316) eine Leitfähigkeit hat, die gemäß einem Erfassungsergebnis variiert, und der Gate-Anschluss des Ansteuertransistors (306) über den Sensor (316) abhängig von der Leitfähigkeit des Sensors (316) entladen wird;
wobei der Sensor (316) ein thermischer oder optischer Sensor mit einer Trägerdichte ist, die sich auf der Grundlage der Absorption thermischer oder optischer Energie aus der Pixelschaltung (300; 330) entsprechend derart ändert, dass der Widerstand des Sensors (316) entsprechend der absorbierten Energie variiert.

2. Displaysystem nach Anspruch 1, wobei der Entladetransistor (310) mit dem Sensor (316) in Reihe liegt.

3. Displaysystem nach Anspruch 1, wobei:
der Gate-Anschluss des ersten Schalttransistors (308) mit einer ersten Auswahlleitung (SEL[i]) zum Betreiben des ersten Schalttransistors (308) verbunden ist, der erste Anschluss des ersten Schalttransistors (308) mit der Datenleitung, die eine Programmierspannung gemäß den Programmierdaten während des Programmierzyklus bereitstellt, verbunden ist, und der zweite Anschluss des ersten Schalttransistors (308) mit dem Gate-Anschluss des Ansteuertransistors (306) verbunden ist;
der Speicherkondensator (310) einen ersten Anschluss und einen zweiten Anschluss aufweist, wobei der erste Anschluss mit dem Gate-Anschluss des Ansteuertransistors (306) und der zweite Anschluss mit dem ersten Anschluss des Ansteuertransistors (306) verbunden ist, wobei der Speicherkondensator (310) angeordnet ist, gemäß den Programmierdaten während des Programmierzyklus geladen zu werden;
der Sensor (316) die Gate-Spannung des Ansteuertransistors (306) einstellt, indem die Spannung an dem Speicherkondensator (310) durch den Sensor (316) während eines Kompensationszyklus im Anschluss an den Programmierzyklus zumindest teilweise abgebaut wird;
der Entladetransistor (310) gemäß einer zweiten Auswahlleitung (SEL[i-1]; SEL[i+1]) betrieben wird und zwischen einem Gate-Anschluss des Ansteuertransistors (306) und dem Sensor (316) in Reihe geschaltet ist; und
eine Steuerung zum Betreiben der Datenleitung, der ersten Auswahlleitung (SEL[i]) und der zweiten Auswahlleitung (SEL[i+1]; SEL[i-1]) vorgesehen ist, derart, dass:
die Programmierspannung während des Programmierzyklus auf der Datenleitung bereitgestellt wird, während der erste Schalttransistor (308) eingeschaltet ist;
die Spannung an dem Speicherkondensator (310) durch den Sensor (316) und den Entladetransistor (310) zumindest teilweise abgebaut wird, indem die zweite Auswahlleitung (SEL[i-1]; SEL[i+1]) so betrieben wird, dass der Entladetransistor (310) während des Kompensationszyklus im Anschluss an den Programmierzyklus eingeschaltet wird, während der erste Schalttransistor (308) ausgeschaltet ist; und
der Ansteuertransistor (306) die lichtemittierende Einrichtung (302; 332) während eines Ansteuerzyklus im Anschluss an den Kompensationszyklus steuert, indem die zweite Auswahlleitung (SEL[i-1]; SEL[i+1]) so betrieben wird, dass der Entladetransistor (310) ausgeschaltet wird.

4. Displaysystem nach Anspruch 2 oder 3, wobei
die lichtemittierende Einrichtung (302; 332) eine organische lichtemittierende Diode ist und die Pixelschaltung (130; 300; 330) mindestens einen Dünnschichttransistor enthält.

5. Displaysystem nach einem der Ansprüche 3 oder 4, wobei die Pixelschaltung (300; 330) eine erste Pixelschaltung (300; 330) aus mehreren ähnlichen Pixelschaltungen in einem Displayarray ist, das in Zeilen und Spalten angeordnet ist, und wobei die zweite Auswahlleitung (SEL[i-1]; SEL[i+1]) eine erste Auswahlleitung für eine zweite Pixelschaltung (300; 330) in dem Displayarray ist, die in einer Zeile benachbart zu einer Zeile liegt, die die erste Pixelschaltung (300; 330) enthält, sodass das Betreiben der Steuerung zur Auswahl der zweiten Auswahlleitung (SEL[i-1]; SEL[i+1]) ermöglicht, dass der Kompensationszyklus in der ersten Pixelschaltung (300; 330) gleichzeitig mit dem Programmierzyklus in der zweiten Pixelschaltung (300; 330) auftritt.

6. Displaysystem nach Anspruch 1, das ferner eine Abrufschaltung (360) zur Erfassung einer Alterung der Pixelschaltung (300; 330) durch Auslesen der an dem Gate-Anschluss des Ansteuertransistors (306) nach dem Kompensationszyklus verbleibenden Spannung aufweist, wobei die Alterung der Pixelschaltung (300, 330) eine Alterung des Ansteuertransistors (306) und der lichtemittierenden Einrichtung (302; 332) mit einschließt, wobei die Steuerung ferner ausgebildet ist, die Abrufschaltung so zu betreiben, dass sie die Alterung der Pixelschaltung (300; 330) erfasst und in Reaktion auf das Erfassens des Alterns der Pixelschaltung (300; 330) Programmierspannungen, die über die Datenleitung bereitgestellt werden, gemäß der Erfassung des Alterns kalibriert;
wobei die Abrufschaltung einen Ladungspumpenverstärker (362), der mit der Datenleitung über einen Schalter (SW1) zum Abrufen der Spannung an dem Gate-Anschluss des Ansteuertransistors (306) und zur Bereitstellung eines Ausgangssignals für die Steuerung verbindbar ist, das für die Alterung der Pixelschaltung (300; 330) kennzeichnend ist, und einen Kondensator (364) aufweist, und
wobei der Ladungspumpenverstärker (362) einen ersten Anschluss, der mit dem Schalter (SW1) verbunden ist, und einen zweiten Schalter aufweist, der mit einer Bias-Spannung (Vb2) verbunden ist, wobei der Kondensator (364) zwischen dem ersten Anschluss und dem Ausgang (366) des Ladungspumpenverstärkers (362) angeschlossen ist, wobei der Ausgang (366) des Ladungspumpenverstärkers (362) abhängig von der Spannung an dem Gate-Anschluss des Ansteuertransistors (306) variiert.

7. Displaysystem nach Anspruch 1 oder 2, das umfasst: eine Abrufschaltung zur Erfassung einer Alterung der Pixelschaltung (300; 330) durch Auslesen der an dem Gate-Anschluss des Ansteuertransistors (306) nach einem auf den Programmierzyklus folgenden Ansteuerzyklus verbleibenden Spannung, wobei die Alterung der Pixelschaltung (300, 330) eine Alterung des Ansteuertransistors (306) und der lichtemittierenden Einrichtung (302; 332) mit einschließt; und
eine Steuerung, die ausgebildet ist, die Abrufschaltung so zu betreiben, dass sie die Alterung der Pixelschaltung (300; 330) erfasst und in Reaktion auf die Erfassung der Alterung der Pixelschaltung (300; 330) Programmierspannungen, die über die Datenleitung bereitgestellt werden, entsprechend der Erfassung der Alterung kalibriert;
wobei die Abrufschaltung einen Trans-Widerstands-Verstärker (402) aufweist, der mit der Datenleitung über einen Schalter (SW2) zum Abrufen der Spannung an dem Gate-Anschluss des Ansteuertransistors (306) und zur Bereitstellung eines Ausgangssignals für die Steuerung, das die Alterung der Pixelschaltung (300; 330) kennzeichnet, verbindbar ist, und
wobei der Trans-Widerstands-Verstärker (402) ein Ausgangssignal hat, das in Abhängigkeit von der Spannung an dem Gate-Anschluss des Ansteuertransistors (306) variiert.

8. Displaysystem nach Anspruch 6, wobei die Abrufschaltung die Alterung der Pixelschaltung (300; 330) durch Vergleich einer Spannung an dem Gate-Anschluss des Ansteuertransistors (306) vor dem Kompensationszyklus und einer Spannung, die an dem Gate-Anschluss des Ansteuertransistors (306) nach dem Kompensationszyklus verbleibt, erfasst, wobei die Differenz zwischen den verglichenen Spannungen in der Steuerung verwendet wird, um die Alterung der Pixelschaltung (300; 330) zu berechnen.

9. Displaysystem nach Anspruch 8, wobei die Steuerung ausgebildet ist, die Programmierspannungen zu kalibrieren, indem die Programmierspannungen gemäß der Differenz zwischen den verglichenen Spannungen, die von der Abrufschaltung gemessen wurden, zu kalibrieren.

10. Displaysystem nach Anspruch 6, wobei die Pixelschaltung (300; 330) eine Referenzpixelschaltung (300; 330) in einem Displayarray ist, das in Zeilen und Spalten angeordnet ist, wobei das Displayarray mehrere Pixelschaltungen aufweist, die einen Sensor (316) zur Erfassung der Alterung der Pixelschaltung nicht enthalten, und wobei die Steuerung die Abrufschaltung so betreibt, dass sie die Programmierspannungen der mehreren Pixelschaltungen, die den Sensor (316) nicht enthalten, gemäß dem Erfassen der Alterung der Referenzpixelschaltung (300; 330) kalibriert.

11. Displaysystem nach Anspruch 6, wobei die Steuerung ferner ausgebildet ist, die zweite Auswahlleitung (SEL[i-1]; SEL[i+1]), die erste Auswahlleitung (SEL[i]), die Datenleitung und die Abrufschaltung derart zu betreiben, dass:
die Leuchtstärke der lichtemittierenden Einrichtung (302; 332) durch den Ansteuertransistor (306) während eines Ansteuerzyklus (382) nach dem Programmierzyklus gesteuert wird, wobei der erste Schalttransistor (308) während des Ansteuerzyklus abgeschaltet ist,
eine Bias-Spannung auf der Datenleitung während eines Initialisierungszyklus (383) nach dem Ansteuerzyklus bereitgestellt wird, während der erste Schalttransistor (308) eingeschaltet ist, um den Speicherkondensator (310) entsprechend der Bias-Spannung zu laden,
der Kompensationszyklus (384) nach dem Initialisierungszyklus ausgeführt wird, während der Entladetransistor (310) eingeschaltet und der erste Schalttransistor (308) ausgeschaltet ist, sodass die Bias-Spannung an dem Speicherkondensator (310) zumindest teilweise über den Entladetransistor (310) und den Sensor (316) abgebaut werden kann, und
die an dem Gate-Anschluss des Ansteuertransistors (306) nach dem Kompensationszyklus verbleibende Spannung von der Abrufschaltung über die Datenleitung während eines Abrufzyklus (386) nach dem Kompensationszyklus abgerufen wird, während der Entladetransistor (310) ausgeschaltet ist und der erste Schalttransistor (308) eingeschaltet ist.

12. Verfahren zum Betreiben eines Displaysystems mit einer Pixelschaltung (300; 330), die eine lichtemittierende Einrichtung (302; 332) aufweist, die ausgebildet ist, Licht gemäß einer Programmierinformation auszusenden, wobei die Pixelschaltung (300; 330) ferner aufweist:
einen Ansteuertransistor (306), der mit der lichtemittierenden Einrichtung (302; 332) in Reihe geschaltet ist, wobei der Ansteuertransistor (306) einen Gate-Anschluss, einen ersten Anschluss und einen zweiten Anschluss aufweist;
einen ersten Schalttransistor (308), der ausgebildet ist, eine Datenleitung selektiv mit dem Gate-Anschluss des Ansteuertransistors (306) zu verbinden, wobei der erste Schalttransistor (308) einen Gate-Anschluss, einen ersten Anschluss und einen zweiten Anschluss aufweist, und wobei die Programmierdaten auf der Datenleitung während eines Programmierzyklus bereitgestellt werden, während der erste Schalttransistor (308) eingeschaltet ist;
einen Speicherkondensator (310), der ausgebildet ist, eine Spannungsdifferenz zwischen dem Gate-Anschluss und dem ersten Anschluss des Ansteuertransistors (306) zu steuern; und
eine Schaltung, die ausgebildet ist, eine Gate-Spannung des Ansteuertransistors (306) einzustellen, wobei die Schaltung einen Sensor (316), der zum Erfassen einer Energieübertragung aus der Pixelschaltung (300; 330) ausgebildet ist, und einen Entladetransistor (310) aufweist, der ausgebildet ist, den Sensor (316) selektiv mit dem Gate-Anschluss des Ansteuertransistors (306) zu verbinden, wobei der Sensor (316) eine Leitfähigkeit hat, die entsprechend einem Erfassungsergebnis variiert, und der Gate-Anschluss des Ansteuertransistors (306) über den Sensor (316) in Abhängigkeit von der Leitfähigkeit des Sensors (316) entladen wird, wobei der Sensor (316) ein thermischer oder optischer Sensor mit einer Trägerdichte ist, die sich auf der Grundlage der Absorption thermischer oder optischer Energie aus der Pixelschaltung (300; 330) entsprechend derart ändert, dass der Widerstand des Sensors (316) gemäß der absorbierten Energie variiert;
wobei das Verfahren umfasst:
Anlegen einer Programmierspannung gemäß Programmierdaten an die Datenleitung während eines Programmierzyklus, während der erste Transistor (308) ausgeschaltet ist, derart, dass der Speicherkondensator (310) gemäß der Programmspierspannung geladen wird;
Einstellen einer Gate-Spannung des Ansteuertransistors (306) mit der Schaltung nach dem Programmierzyklus durch Betreiben des Entladetransistors (310) derart, dass er den Sensor (316) mit dem Gate-Anschluss des Ansteuertransistors (306) verbindet, sodass der Gate-Anschluss des Ansteuertransistors (306) über den Sensor (316) in Abhängigkeit von der Leitfähigkeit des Sensors (316) entladen wird;
Steuern der lichtemittierenden Einrichtung (302; 332) während eines Ansteuerzyklus nach der Einstellung der Gate-Spannung des Ansteuertransistors (306) durch Ausschalten des Entladetransistors (310).

13. Verfahren nach Anspruch 12, wobei das Verfahren ferner umfasst:
Anlegen einer zweiten Programmierspannung an die Datenleitung für eine zweite Pixelschaltung (300; 330), die einen Schalttransistor hat, der von der zweiten Auswahlleitung (SEL[i-1]; SEL[i+1]) so betrieben wird, dass er einen Speicherkondensator (310) in der zweiten Pixelschaltung (300; 330) mit der Datenleitung verbindet und dadurch gleichzeitig die zweite Pixelschaltung (300; 330) gemäß der zweiten Programmierspannung programmiert, während ein Kompensationszyklus in der ersten Pixelschaltung (300; 330) ausgeführt wird.

14. Verfahren zum Betreiben eines Displaysystems mit einer Pixelschaltung (300; 330), die eine lichtemittierende Einrichtung (302; 332) aufweist, die ausgebildet ist, Licht gemäß einer Programmierinformation auszusenden, wobei die Pixelschaltung (300; 330) ferner aufweist:
einen Ansteuertransistor (306), der mit der lichtemittierenden Einrichtung (302; 332) in Reihe geschaltet ist, wobei der Ansteuertransistor (306) einen Gate-Anschluss, einen ersten Anschluss und einen zweiten Anschluss aufweist;
einen ersten Schalttransistor (308), der ausgebildet ist, eine Datenleitung selektiv mit dem Gate-Anschluss des Ansteuertransistors (306) zu verbinden, wobei der erste Schalttransistor (308) einen Gate-Anschluss, einen ersten Anschluss und einen zweiten Anschluss aufweist, und wobei die Programmierdaten auf der Datenleitung während eines Programmierzyklus bereitgestellt werden, während der erste Schalttransistor (308) eingeschaltet ist;
einen Speicherkondensator (310), der ausgebildet ist, eine Spannungsdifferenz zwischen dem Gate-Anschluss und dem ersten Anschluss des Ansteuertransistors (306) zu steuern;
eine Schaltung, die ausgebildet ist, eine Gate-Spannung des Ansteuertransistors (306) einzustellen, wobei die Schaltung einen Sensor (316), der zur Erfassung einer Energieübertragung aus der Pixelschaltung (300; 330) ausgebildet ist, und einen Entladetransistor (310) aufweist, der ausgebildet ist, den Sensor (316) selektiv mit dem Gate-Anschluss des Ansteuertransistors (306) zu verbinden, wobei der Sensor (316) eine Leitfähigkeit hat, die entsprechend einem Erfassungsergebnis variiert, und der Gate-Anschluss des Ansteuertransistors (306) über den Sensor (316) in Abhängigkeit von der Leitfähigkeit des Sensors (316) entladen wird, wobei der Sensor (316) ein thermischer oder optischer Sensor mit einer Trägerdichte ist, die auf der Grundlage der Absorption thermischer oder optischer Energie aus der Pixelschaltung (300; 330) entsprechend sich so ändert, dass der Widerstand des Sensors (316) gemäß der absorbierten Energie variiert; und
eine Abrufschaltung, die über die Datenleitung mit der Pixelschaltung (300; 330) verbunden ist,
wobei das Verfahren umfasst:
Anlegen einer Programmierspannung gemäß Programmierdaten an die Datenleitung während eines Programmierzyklus, während der erste Schalttransistor (308) ausgeschaltet ist, sodass der Speicherkondensator (310) gemäß der Programmierspannung geladen wird;
Steuern der lichtemittierenden Einrichtung (302; 332) durch den Ansteuertransistor (306) während eines auf den Programmierzyklus folgenden Ansteuerzyklus;
Aufladen des Gate-Anschlusses des Ansteuertransistors (306) auf eine Bias-Spannung während eines auf den Ansteuerzyklus folgenden Initialisierungszyklus;
Einstellen einer Gate-Spannung des Ansteuertransistors (306) mit der Schaltung während eines auf den Initialisierungszyklus folgenden Integrationszyklus durch Betreiben des Entladetransistors (310) derart, dass er den Sensor (316) mit dem Gate-Anschluss des Ansteuertransistors (306) verbindet, sodass der Gate-Anschluss des Ansteuertransistors (306) über dem Sensor (316) in Abhängigkeit von der Leitfähigkeit des Sensors (316) entladen wird;
Erfassen einer Alterung der Pixelschaltung (300; 330) durch Auslesen der an dem Gate-Anschluss des Ansteuertransistors (306) nach dem Integrationszyklus verbleibenden Spannung über die Abrufschaltung, wobei die Alterung der Pixelschaltung (300, 330) eine Alterung des Ansteuertransistors (306) und der lichtemittierenden Einrichtung (302; 332) mit einschließt; und
Kalibrieren der Programmierspannungen, die auf der Datenleitung bereitgestellt werden, gemäß der erfassten Alterung.

15. Verfahren nach Anspruch 14, wobei das Kalibrieren der Programmierspannungen umfasst:
Vergleichen einer Spannung an dem Gate-Anschluss des Ansteuertransistors (306) vor dem Integrationszyklus mit einer Spannung, die an dem Gate-Anschluss des Ansteuertransistors (306) nach dem Integrationszyklus verbleibt;
Berechnen der Alterung der Pixelschaltung (300; 330) auf der Grundlage der Differenz zwischen den verglichenen Spannungen; und
Skalieren der Programmierspannungen, die an der Datenleitung angelegt werden, gemäß der berechneten Alterung.

## Revendications

1. Système d'affichage comprenant :
un circuit de pixels (300 ; 330) comprenant un dispositif électroluminescent (302 ; 332) adapté pour émettre de la lumière conformément à des données de programmation, le circuit de pixels (300 ; 330) incluant en outre :
un transistor d'attaque (306) connecté en série au dispositif électroluminescent (302 ; 332), le transistor d'attaque (306) incluant une borne de grille, une première borne et une deuxième borne ;
un premier transistor de commutation (308) adapté pour connecter sélectivement une ligne de données à la borne de grille du transistor d'attaque (306), le premier transistor de commutation (308) incluant une borne de grille, une première borne et une deuxième borne, les données de programmation étant fournies sur la ligne de données au cours d'un cycle de programmation alors que le premier transistor de commutation (308) est activé ;
un condensateur de stockage (310) adapté pour contrôler une différence de tension entre la borne de grille et la première borne du transistor d'attaque (306) ; et
un circuit adapté pour ajuster une tension de grille du transistor d'attaque (306), le circuit comprenant un capteur (316) adapté pour détecter un transfert d'énergie depuis le circuit de pixels (300 ; 330) et un transistor de décharge (310) adapté pour coupler sélectivement le capteur (316) à la borne de grille du transistor d'attaque (306), dans lequel le capteur (316) a une conductance qui varie lors d'un résultat de détection, et la borne de grille du transistor d'attaque (306) est déchargée via le capteur (316) en fonction de la conductance du capteur (316) ;
dans lequel le capteur (316) est un capteur thermique ou optique dont la densité de porteurs change sur base de l'absorption d'énergie respectivement thermique ou optique provenant du circuit de pixels (300 ; 330), de telle sorte que la résistance du capteur (316) varie en fonction de l'énergie absorbée.

2. Système d'affichage selon la revendication 1, dans lequel le transistor de décharge (310) est en série avec le capteur (316).

3. Système d'affichage selon la revendication 1, dans lequel :
la borne de grille du premier transistor de commutation (308) est connectée à une première ligne de sélection (SEL[i]) pour commander le premier transistor de commutation (308), la première borne du premier transistor de commutation (308) étant connectée à la ligne de données procurant une tension de programmation selon les données de programmation au cours du cycle de programmation, la deuxième borne du premier transistor de commutation (308) étant connectée à la borne de grille du transistor d'attaque (306) ;
le condensateur de stockage (310) inclut une première borne et une deuxième borne, la première borne étant connectée à la borne de grille du transistor d'attaque (306) et la deuxième borne étant connectée à la première borne du transistor d'attaque (306), le condensateur de stockage (310) étant agencé pour être chargé selon les données de programmation au cours du cycle de programmation ;
le capteur (316) ajuste la tension de grille du transistor d'attaque (306) en déchargeant au moins partiellement la tension sur le condensateur de stockage (310) via le capteur (316) au cours d'un cycle de compensation postérieur au cycle de programmation ;
le transistor de décharge (310) est commandé en fonction d'une deuxième ligne de sélection (SEL[i-1] ; SEL[i+1]) et connecté en série entre la borne de grille du transistor d'attaque (306) et le capteur (316) ; et
un contrôleur sert à commander la ligne de données, la première ligne de sélection (SEL[i]) et la deuxième ligne de sélection (SEL[i+1] ; SEL[i-1]) de telle sorte que :
la tension de programmation est fournie sur la ligne de données au cours du cycle de programmation alors que le premier transistor de commutation (308) est activé ;
la tension sur le condensateur de stockage (310) est au moins partiellement déchargée via le capteur (316) et le transistor de décharge (310) en commandant la deuxième ligne de sélection (SEL[i-1] ; SEL[i+1]) pour activer le transistor de décharge (310) au cours dudit cycle de compensation postérieur au cycle de programmation alors que le premier transistor de commutation (308) est désactivé ; et
le transistor d'attaque (306) contrôle le dispositif électroluminescent (302 ; 332) au cours d'un cycle d'attaque postérieur au cycle de compensation en commandant la deuxième ligne de sélection (SEL [i-1] ; SEL[i+1]) pour désactiver le transistor de décharge (310).

4. Système d'affichage selon la revendication 2 ou 3, dans lequel
le dispositif électroluminescent (302 ; 332) est une diode électroluminescente organique et le circuit de pixels (130 ; 300 ; 330) comprend au moins un transistor en couches minces.

5. Système d'affichage selon l'une quelconque des revendications 3 et 4, dans lequel le circuit de pixels (300 ; 330) est un premier circuit de pixels (300 ; 330) dans une pluralité de circuits de pixels similaires dans un réseau d'affichage agencé en rangées et colonnes et dans lequel la deuxième ligne de sélection (SEL[i-1] ; SEL[i+1]) est une première ligne de sélection pour un deuxième circuit de pixels (300 ; 330) dans le réseau d'affichage situé dans une rangée adjacente à une rangée incluant le premier circuit de pixels (300 ; 330), de telle sorte que la commande du contrôleur pour sélectionner la deuxième ligne de sélection (SEL[i-1] ; SEL[i+1]) permet une exécution simultanée du cycle de compensation dans le premier circuit de pixels (300 ; 330) et du cycle de programmation dans le deuxième circuit de pixels (300 ; 330).

6. Système d'affichage selon la revendication 1, comprenant en outre un circuit de relecture (360) pour détecter le vieillissement du circuit de pixels (300 ; 330) en lisant la tension restante sur la borne de grille du transistor d'attaque (306) après le cycle de compensation, ledit vieillissement du circuit de pixels (300, 330) incluant le vieillissement du transistor d'attaque (306) et du dispositif électroluminescent (302 ; 332), dans lequel un contrôleur est en outre configuré pour commander le circuit de relecture afin de détecter le vieillissement du circuit de pixels (300 ; 330) et, en réponse à la détection du vieillissement du circuit de pixels (300 ; 330), pour étalonner des tensions de programmation fournies via la ligne de données en fonction de la détection du vieillissement ;
dans lequel le circuit de relecture comprend un amplificateur à pompe de charge (362) connectable à la ligne de données via un commutateur (SW1) pour relire la tension sur la borne de grille du transistor d'attaque (306) et procurer une sortie au contrôleur qui est indicative du vieillissement du circuit de pixels (300 ; 330), et un condensateur (364), et
dans lequel l'amplificateur de pompe de charge (362) comporte une première borne connectée au commutateur (SW1) et une deuxième borne connectée à une tension de polarisation (Vb2), le condensateur (364) étant connecté entre la première borne et la sortie (366) de l'amplificateur à pompe de charge (362), la sortie (366) de l'amplificateur à pompe de charge (362) variant en fonction de la tension de la borne de grille du transistor d'attaque (306).

7. Système d'affichage selon la revendication 1 ou 2, comprenant en outre : un circuit de relecture pour détecter le vieillissement du circuit de pixels (300 ; 330) en lisant la tension restante sur la borne de grille du transistor d'attaque (306) après un cycle de compensation qui suit le cycle de programmation, ledit vieillissement du circuit de pixels (300, 330) incluant le vieillissement du transistor d'attaque (306) et du dispositif électroluminescent (302 ; 332) ; et
un contrôleur est en outre configuré pour commander le circuit de relecture afin de détecter le vieillissement du circuit de pixels (300 ; 330) et, en réponse à la détection du vieillissement du circuit de pixels (300 ; 330), pour étalonner des tensions de programmation fournies via la ligne de données en fonction de la détection du vieillissement ;
dans lequel le circuit de relecture comprend un amplificateur à transrésistance (402) connectable à la ligne de données via un commutateur (SW2) pour relire la tension sur la borne de grille du transistor d'attaque (306) et procurer une sortie au contrôleur qui est indicative du vieillissement du circuit de pixels (300 ; 330), et
dans lequel l'amplificateur à transrésistance (402) a une sortie qui varie en fonction de la tension sur la borne de grille du transistor d'attaque (306).

8. Système d'affichage selon la revendication 6, dans lequel le circuit de relecture détecte le vieillissement du circuit de pixels (300 ; 330) en comparant une tension sur la borne de grille du transistor d'attaque (306) avant le cycle de compensation et une tension restante sur la borne de grille du transistor d'attaque (306) après le cycle de compensation, la différence entre les tensions comparées étant utilisée dans le contrôleur pour calculer le vieillissement du circuit de pixels (300 ; 330).

9. Système d'affichage selon la revendication 8, dans lequel le contrôleur est configuré pour étalonner les tensions de programmation en ajustant les tensions de programmation en fonction de la différence entre les tensions comparées mesurées par le circuit de relecture.

10. Système d'affichage selon la revendication 6, dans lequel le circuit de pixels (300 ; 330) est un circuit de pixels de référence (300 ; 330) dans un réseau d'affichage agencé en rangées et colonnes, le réseau d'affichage incluant une pluralité de circuits de pixels n'incluant pas un capteur (316) pour détecter le vieillissement des circuits de pixels, et dans lequel le contrôleur commande le circuit de relecture pour étalonner les tensions de programmation de la pluralité de circuits de pixels n'incluant pas le capteur (316) en fonction de la détection du vieillissement du circuit de pixels de référence (300 ; 330).

11. Système d'affichage selon la revendication 6, dans lequel le contrôleur est en outre configuré pour commander la deuxième ligne de sélection (SEL[i-1] ; SEL[i+1]), la première ligne de sélection (SEL[i]), la ligne de données et le circuit de relecture de telle sorte que :
la luminance émise par le dispositif électroluminescent (302 ; 332) est contrôlée par le transistor d'attaque (306) au cours d'un cycle d'attaque (382) postérieur au cycle de programmation, le premier transistor de commutation (308) étant désactivé au cours du cycle d'attaque,
une tension de polarisation est pourvue sur la ligne de données au cours d'un cycle d'initialisation (383) postérieur au cycle d'attaque alors que le premier transistor de commutation (308) est activé pour charger le condensateur de stockage (310) en fonction de la tension de polarisation,
le cycle de compensation (384) est mis en oeuvre après le cycle d'initialisation alors que le transistor de décharge (310) est activé et que le premier transistor de commutation (308) est désactivé pour permettre à la tension de polarisation sur le condensateur de stockage (310) de se décharger au moins partiellement via le transistor de décharge (310) et le capteur (316), et
la tension restante sur la borne de grille du transistor d'attaque (306) après le cycle de compensation étant lue par le circuit de relecture, via la ligne de données, au cours d'un cycle de relecture (386) postérieur au cycle de compensation alors que le transistor de décharge (310) est désactivé et que le premier transistor de commutation (308) est activé.

12. Procédé de commande d'un système d'affichage incluant un circuit de pixels (300 ; 330) comprenant un dispositif électroluminescent (302 ; 332) adapté pour émettre de la lumière conformément à de l'information de programmation, le circuit de pixels (300 ; 330) comprenant en outre :
un transistor d'attaque (306) connecté en série au dispositif électroluminescent (302 ; 332), le transistor d'attaque (306) incluant une borne de grille, une première borne et une deuxième borne ;
un premier transistor de commutation (308) adapté pour connecter sélectivement une ligne de données à la borne de grille du transistor d'attaque (306), le premier transistor de commutation (308) incluant une borne de grille, une première borne et une deuxième borne, les données de programmation étant fournies sur la ligne de données au cours d'un cycle de programmation alors que le premier transistor de commutation (308) est activé ;
un condensateur de stockage (310) adapté pour contrôler une différence de tension entre la borne de grille et la première borne du transistor d'attaque (306) ; et
un circuit configuré pour ajuster une tension de grille du transistor d'attaque (306), le circuit comprenant un capteur (316) adapté pour détecter un transfert d'énergie depuis le circuit de pixels (300 ; 330) et un transistor de décharge (310) adapté pour coupler sélectivement le capteur (316) à la borne de grille du transistor d'attaque (306), dans lequel le capteur (316) a une conductance qui varie lors d'un résultat de détection, et la borne de grille du transistor d'attaque (306) est déchargée via le capteur (316) en fonction de la conductance du capteur (316), dans lequel le capteur (316) est un capteur thermique ou optique dont la densité de porteurs change sur base de l'absorption d'énergie respectivement thermique ou optique provenant du circuit de pixels (300 ; 330), de telle sorte que la résistance du capteur (316) varie en fonction de l'énergie absorbée ;
le procédé comprenant :
l'application d'une tension de programmation en fonction de données de programmation sur la ligne de données au cours d'un cycle de programmation alors que le premier transistor de commutation (308) est activé, de telle sorte que le condensateur de stockage (310) est chargé en fonction de la tension de programmation ;
l'ajustement d'une tension de grille du transistor d'attaque (306) avec le circuit après le cycle de programmation en commandant le transistor de décharge (310) pour connecter le capteur (316) à la borne de grille du transistor d'attaque (306) de telle sorte que la borne de grille du transistor d'attaque (306) est déchargée via le capteur (316) en fonction de la conductance du capteur (316) ;
le contrôle du dispositif électroluminescent (302 ; 332) au cours d'un cycle d'attaque après l'ajustement de la tension de grille du transistor d'attaque (306) en désactivant le transistor de décharge (310).

13. Procédé selon la revendication 12, le procédé comprenant en outre :
l'application d'une deuxième tension de programmation à la ligne de données pour un deuxième circuit de pixels (300 ; 330) ayant un transistor de commutation commandé par la deuxième ligne de sélection (SEL[i-1] ; SEL[i+1]) pour connecter un condensateur de stockage (310) dans le deuxième circuit de pixels (300 ; 330) à la ligne de données et pour programmer ainsi simultanément le deuxième circuit de pixels (300 ; 330) en fonction de la deuxième tension de programmation alors qu'un cycle de compensation est mis en oeuvre dans le premier circuit de pixels (300 ; 330).

14. Procédé de commande d'un système d'affichage incluant un circuit de pixels (300 ; 330) comprenant un dispositif électroluminescent (302 ; 332) adapté pour émettre de la lumière conformément à de l'information de programmation, le circuit de pixels (300 ; 330) comprenant en outre :
un transistor d'attaque (306) connecté en série au dispositif électroluminescent (302 ; 332), le transistor d'attaque (306) incluant une borne de grille, une première borne et une deuxième borne ;
un premier transistor de commutation (308) adapté pour connecter sélectivement une ligne de données à la borne de grille du transistor d'attaque (306), le premier transistor de commutation (308) incluant une borne de grille, une première borne et une deuxième borne, les données de programmation étant fournies sur la ligne de données au cours d'un cycle de programmation alors que le premier transistor de commutation (308) est activé ;
un condensateur de stockage (310) adapté pour contrôler une différence de tension entre la borne de grille et la première borne du transistor d'attaque (306) ;
un circuit configuré pour ajuster une tension de grille du transistor d'attaque (306), le circuit comprenant un capteur (316) adapté pour détecter un transfert d'énergie depuis le circuit de pixels (300 ; 330) et un transistor de décharge (310) adapté pour coupler sélectivement le capteur (316) à la borne de grille du transistor d'attaque (306), dans lequel le capteur (316) a une conductance qui varie lors d'un résultat de détection, et la borne de grille du transistor d'attaque (306) est déchargée via le capteur (316) en fonction de la conductance du capteur (316), dans lequel le capteur (316) est un capteur thermique ou optique dont la densité de porteurs change sur base de l'absorption d'énergie respectivement thermique ou optique provenant du circuit de pixels (300 ; 330), de telle sorte que la résistance du capteur (316) varie en fonction de l'énergie absorbée ; et
un circuit de relecture connecté au circuit de pixels (300 ; 330) via la ligne de données,
le procédé comprenant :
l'application d'une tension de programmation en fonction de données de programmation sur la ligne de données au cours d'un cycle de programmation alors que le premier transistor de commutation (308) est activé, de telle sorte que le condensateur de stockage (310) est chargé en fonction de la tension de programmation ;
le contrôle du dispositif électroluminescent (302 ; 332) par le transistor d'attaque (306) au cours d'un cycle d'attaque postérieur au cycle de programmation ;
le chargement de la borne de grille du transistor d'attaque (306) à une tension de polarisation au cours d'un cycle d'initialisation postérieur au cycle d'attaque ;
l'ajustement d'une tension de grille du transistor d'attaque (306) avec le circuit au cours d'un cycle d'intégration postérieur au cycle d'initialisation en commandant le transistor de décharge (310) pour connecter le capteur (316) à la borne de grille du transistor d'attaque (306) de telle sorte que la borne de grille du transistor d'attaque (306) est déchargée via le capteur (316) en fonction de la conductance du capteur (316) ;
la détection d'un vieillissement du circuit de pixels (300 ; 330) en lisant la tension restante sur la borne de grille du transistor d'attaque (306) après le cycle d'intégration, via le circuit de relecture, ledit vieillissement du circuit de pixels (300, 330) incluant le vieillissement du transistor d'attaque (306) et du dispositif électroluminescent (302 ; 332) ; et
l'étalonnage des tensions de programmation fournies sur la ligne de données en fonction du vieillissement détecté.

15. Procédé selon la revendication 14, dans lequel l'étalonnage des tensions de programmation comprend :
la comparaison d'une tension sur la borne de grille du transistor d'attaque (306) avant le cycle d'intégration et d'une tension restante sur la borne de grille du transistor d'attaque (306) après le cycle d'intégration ;
le calcul du vieillissement du circuit de pixels (300 ; 330) sur base de la différence entre les tensions comparées ; et
l'ajustement des tensions de programmation appliquées à la ligne de données en fonction du vieillissement calculé.
